# EUROPEAN PATENT APPLICATION

(11) **EP 4 598 312 A1**
(43) Date of publication of application: **06.08.2025**
(21) Application number: 24217863.0
(22) Date of filing: 05.12.2024
(51) Int. Cl.: H10H 29/32, H10H 29/49

(54) **DISPLAY DEVICE**

(30) Priority: 05.02.2024 KR 20240017500
(71) Applicant: Samsung Display Co., Ltd., Yongin-si, Gyeonggi-do 17113 (KR)
(72) Inventor: Hong, Sung Chul, 17113 Yongin-si, Gyeonggi-do, (KR); Park, Do Yeong, 17113 Yongin-si, Gyeonggi-do, (KR); Pyo, Ki Hyun, 17113 Yongin-si, Gyeonggi-do, (KR)
(74) Representative: Gulde & Partner

(57) **Abstract**

A display device includes a pixel circuit layer disposed on a substrate; an anode electrode disposed on the pixel circuit layer; a cathode electrode disposed on the pixel circuit layer and spaced apart from the anode electrode; and a first light emitting element and a second light emitting element electrically connected in parallel between the anode electrode and the cathode electrode. The first light emitting element and the second light emitting element may be spaced apart from each other in a second direction and oriented diagonally.

## Description

### BACKGROUND

### 1. Technical Field

Various embodiments relate to a display device.

### 2. Description of the Related Art

With the development of information technology, the importance of a display device, which is a connection medium between a user and information, has been emphasized. Owing to the importance of display devices, the use of various kinds of display devices, such as a liquid crystal display device and an organic light-emitting display device, has increased.

Display devices may display an image through sub-pixels. Each of the sub-pixels may include a light emitting element. In the case where a defect occurs in a light emitting element included in any one of the sub-pixels, the corresponding sub-pixel may be displayed as a dark spot, or the color displayed by a pixel including the sub-pixel may be distorted.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

Various embodiments are directed to a display device in which a sub-pixel can function as a normal light emitting element even if a defect occurs in any one light emitting element.

An embodiment may provide a display; a pixel circuit layer disposed on a substrate; an anode electrode disposed on the pixel circuit layer; a cathode electrode disposed on the pixel circuit layer and spaced apart from the anode electrode; and a first light emitting element and a second light emitting element electrically connected in parallel between the anode electrode and the cathode electrode. The first light emitting element and the second light emitting element may be spaced apart from each other in a second direction and oriented diagonally.

In an embodiment, an angle between a first line connecting respective centers of the first light emitting element and the second light emitting element and a second line connecting a center of an area where the first light emitting element overlaps the cathode electrode and a center of an area where the first light emitting element overlaps the anode electrode may be greater than about 0° and less than about 90°, preferably 15°, 30°, 45°, or 60°.

In an embodiment, the pixel circuit layer includes a plurality of sub-pixels and the first light emitting element and the second light emitting element may be included in a single sub-pixel.

In an embodiment, the cathode electrode may have a substantially mesh structure.

In an embodiment, the cathode electrode may include a plurality of first line components extending in a first direction perpendicular to the second direction; and a plurality of second line components extending in the second direction and respectively connected to the plurality of first line components.

In an embodiment, the cathode electrode may further include a protrusion protruding from each of the first line components in a direction toward the first light emitting element or the second light emitting element.

In an embodiment, the cathode electrode may further include a protrusion protruding from each of the plurality of second line components in a direction toward the first light emitting element or the second light emitting element.

In an embodiment, the display device may further include a bank including at least one opening through which the first light emitting element and the second light emitting element are exposed.

In an embodiment, the first light emitting element and the second light emitting element may be exposed through the one opening of the bank.

In an embodiment, the first light emitting element may be exposed through a first opening of the bank, and the second light emitting element may be exposed through a second opening of the bank separated from the first opening of the bank.

An embodiment may provide a display device, including a display panel including a plurality of sub-pixels; a gate driver electrically connected to the plurality of sub-pixels in a first direction; and a data driver electrically connected to the plurality of sub-pixels in a second direction perpendicular to the first direction. Each of the plurality of sub-pixels may include a first light emitting element and a second light emitting element electrically connected in parallel between an anode electrode and a cathode electrode.

In an embodiment, the first light emitting element and the second light emitting element included in each of the plurality of sub-pixels may be disposed in the corresponding sub-pixel at positions spaced apart from each other in the second direction.

In an embodiment, the first light emitting element and the second light emitting element may be spaced apart from each other in the second direction and oriented diagonally.

In an embodiment, an angle between a first line connecting respective centers of the first light emitting element and the second light emitting element and a second line connecting a center of an area where the first light emitting element may overlap the cathode electrode and a center of an area where the first light emitting element may overlap the anode electrode may be greater than about 0° and less than about 90°.

In an embodiment, at least one of the first light emitting element and the second light emitting element may be electrically connected to the cathode electrode and the anode electrode in the second direction.

In an embodiment, at least one of the first light emitting element and the second light emitting element may be electrically connected to the cathode electrode and the anode electrode in the first direction.

In an embodiment, the cathode electrode may have a substantially mesh structure.

In an embodiment, the plurality of sub-pixels may be disposed in a linear line in the first direction and disposed in a zigzag pattern in the second direction.

In an embodiment, the plurality of sub-pixels included in an i-th row and an (i+1)-th row may share a cathode electrode extending in the first direction (where i is an even or odd number greater than 0).

### BRIEF DESCRIPTION OF THE DRAWINGS

The above and other aspects and features of the disclosure will become more apparent by describing in detail embodiments thereof with reference to the attached drawings, in which:
FIG. 1 is a block diagram illustrating an embodiment of a display device.
FIG. 2 is a block diagram illustrating an embodiment of any one of sub-pixels of FIG. 1.
FIG. 3 is a schematic plan view illustrating an embodiment of a display panel of FIG. 1.
FIG. 4 is a schematic sectional view illustrating an embodiment of the display panel of FIG. 3.
FIG. 5 is a schematic sectional view illustrating an embodiment of the display panel of FIG. 3.
FIG. 6 is a schematic plan view illustrating an embodiment of any one of pixels of FIG. 3.
FIG. 7 is a schematic sectional view taken along line I-I' of FIG. 6.
FIG. 8 is a schematic sectional view taken along line II-II' of FIG. 6.
FIG. 9 is a block diagram illustrating an embodiment of any one of the sub-pixels of FIG. 1.
FIG. 10 is a schematic plan view illustrating a pixel included in a display device in accordance with an embodiment.
FIG. 11 is a schematic plan view illustrating a pixel included in a display device in accordance with an embodiment.
FIG. 12 is a diagram for describing a bank of the pixel illustrated in FIG. 10 or 11.
FIG. 13 is a diagram illustrating only a first bank BANK1 of FIG. 12.
FIG. 14 is a schematic plan view illustrating a pixel included in a display device in accordance with an embodiment.
FIG. 15 is a schematic plan view illustrating a pixel included in a display device in accordance with an embodiment.
FIG. 16 is a schematic plan view illustrating a pixel included in a display device in accordance with an embodiment.
FIG. 17 is a schematic plan view illustrating a pixel included in a display device in accordance with an embodiment.
FIG. 18 is a schematic plan view illustrating another example of the display panel of FIG. 1.
FIG. 19 is a schematic plan view illustrating an embodiment of sub-pixels of FIG. 18.
FIG. 20 is a block diagram illustrating an embodiment of a display system.
FIGS. 21 to 24 are schematic perspective views illustrating application examples of a display system of FIG. 20.

### DETAILED DESCRIPTION OF THE EMBODIMENTS

Hereinafter, embodiments will be described in detail with reference to the attached drawings. In the following description, parts required for understanding the disclosure will be described, and explanation of the other parts may be omitted. Accordingly, the disclosure is not limited to the embodiments set forth herein but may be embodied in other types. Rather, these embodiments are provided so that the disclosure will be thorough and complete, and will fully convey the the disclosure to those skilled in the art.

It will be understood that when an element is referred to as being "coupled" or "connected" to another element, it can be directly coupled or connected to the other element or intervening elements may be present therebetween. The terminology used herein is for the purpose of describing various embodiments only and is not intended to be limiting.

In the drawings, sizes, thicknesses, ratios, and dimensions of the elements may be exaggerated for ease of description and for clarity. Like numbers refer to like elements throughout.

As used herein, the singular forms, "a," "an," and "the" are intended to include the plural forms as well, unless the context clearly indicates otherwise.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

In the specification and the claims, the phrase "at least one of" is intended to include the meaning of "at least one selected from the group of" for the purpose of its meaning and interpretation. For example, "at least one of A and B" may be understood to mean "A, B, or A and B."

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

The terms "face" and "facing" mean that a first element may directly or indirectly oppose a second element. In a case in which a third element intervenes between the first and second element, the first and second element may be understood as being indirectly opposed to one another, although still facing each other.

When an element is described as `not overlapping' or 'to not overlap' another element, this may include that the elements are spaced apart from each other, offset from each other, or set aside from each other or any other suitable term as would be appreciated and understood by those of ordinary skill in the art.

The terms "comprises," "comprising," "includes," and/or "including," "has," "have," and/or "having," and variations thereof when used in this specification, specify the presence of stated features, integers, steps, operations, elements, components, and/or groups thereof, but do not preclude the presence or addition of one or more other features, integers, steps, operations, elements, components, and/or groups thereof.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), and the like, may be used herein for descriptive purposes, and, thereby, to describe one element or feature's relationship to another element(s) or feature(s), as illustrated in the drawings. Spatially relative terms are intended to encompass different orientations of an apparatus in use, operation, and/or manufacture in addition to the orientation depicted in the drawings. For example, if the device in the drawings is turned upside down, elements described as "below" or "beneath" other elements or features would then be oriented "above" the other elements or features. Thus, the term "below" can encompass both an orientation of above and below. Furthermore, the device may be otherwise oriented (for example, rotated 90 degrees or at other orientations), and, as such, the spatially relative descriptors used herein interpreted accordingly.

Herein, various embodiments will be described with reference to drawings that are schematic illustrations of idealized embodiments. As such, variations from the shapes of the illustrations as a result, for example, of manufacturing techniques and/or tolerances, are to be expected. Therefore, embodiments disclosed herein should not be construed as limited to the particular illustrated shapes of regions, but are to include deviations in shapes that result from, for instance, manufacturing. As such, the shapes illustrated in the drawings may not illustrate the actual shapes of regions of a device, and, as such, are not intended to be limiting.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied herein, all terms (including technical and scientific terms) used herein have the same meaning as commonly understood by one of ordinary skill in the art to which the disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Embodiments may be described and illustrated in the accompanying drawings in terms of functional blocks, units, and/or modules.

Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies.

In the case of the blocks, units, and/or modules being implemented by microprocessors or other similar hardware, they may be programmed and controlled using software (for example, microcode) to perform various functions discussed herein and may optionally be driven by firmware and/or software.

It is also contemplated that each block, unit, and/or module may be implemented by dedicated hardware, or as a combination of dedicated hardware to perform some functions and a processor (for example, one or more programmed microprocessors and associated circuitry) to perform other functions.

Each block, unit, and/or module of embodiments may be physically separated into two or more interacting and discrete blocks, units, and/or modules without departing from the scope of the disclosure.

Further, the blocks, units, and/or modules of embodiments may be physically combined into more complex blocks, units, and/or modules without departing from the scope of the disclosure.

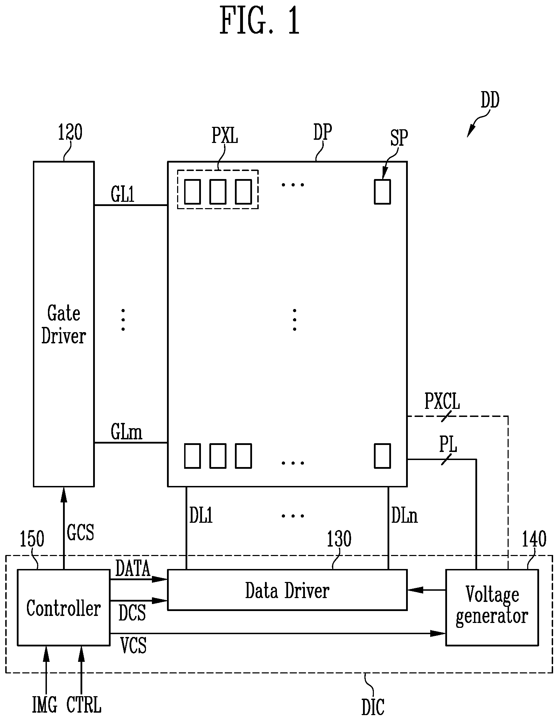

FIG. 1 is a block diagram illustrating an embodiment of a display device DD.

Referring to FIG. 1, the display device DD may include a display panel DP, a gate driver 120, a data driver 130, a voltage generator 140, and a controller 150.

The display panel DP may include sub-pixels SP. The sub-pixels SP may be connected to the gate driver 120 through first to m-th gate lines GL1 to GLm. The sub-pixels SP may be connected to the data driver 130 through first to n-th data lines DL1 to DLn.

The sub-pixels SP may generate light in two or more colors. For example, each of the sub-pixels SP may generate light in a color such as red, green, blue, cyan, magenta, or yellow.

Two or more sub-pixels among the sub-pixels SP may form one pixel PXL. For example, the pixel PXL may include three sub-pixels, as illustrated in FIG. 1. As such, the pixel PXL may emit light of various colors and various luminances depending on the combination of light emitted from the sub-pixels included therein.

The gate driver 120 may be connected to sub-pixels SP arranged (or disposed) in a row direction through first to m-th gate lines GL1 to GLm. The gate driver 120 may output gate signals to the first to m-th gate lines GL1 to GLm in response to a gate control signal GCS. In embodiments, the gate control signal GCS may include a start signal instructing each frame to start, a horizontal synchronization signal, and the like within the scope of the disclosure.

The gate driver 120 may be disposed on one side or a side of the display panel DP. However, embodiments are not limited to the aforementioned example. For example, the gate driver 120 may be divided into two or more drivers that are physically and/or logically distinguished from each other. The drivers may be disposed on a first side of the display panel DP and a second side of the display panel DP opposite to the first side. As such, the gate driver 120 may be disposed around the display panel DP in various forms depending on the embodiments.

The data driver 130 may be connected to sub-pixels SP arranged (or disposed) in a column direction through the first to n-th data lines DL1 to DLn. The data driver 130 may receive image data DATA and a data control signal DCS from the controller 150. The data driver 130 may operate in response to the data control signal DCS. In embodiments, the data control signal DCS may include a source start signal, a source shift clock, a source output enable signal, and the like within the scope of the disclosure.

The data driver 130 may receive voltages from the voltage generator 140. The data driver 130 may apply, using received voltages, data signals having grayscale voltages corresponding to the image data DATA to the first to n-th data lines DL1 to DLn. In case that a gate signal is applied to each of the first to m-th gate lines GL1 to GLm, data signals corresponding to the image data DATA may be applied to the data lines DL1 to DLn. Hence, the sub-pixels SP may generate light corresponding to the data signals, and the display panel DP may display an image.

In embodiments, the gate driver 120 and the data driver 130 may include complementary metal-oxide semiconductor (CMOS) circuit elements.

The voltage generator 140 may operate in response to a voltage control signal VCS provided from the controller 150. The voltage generator 140 is configured to generate voltages and provide the generated voltages to components of the display device DD such as the gate driver 120, the data driver 130, and the controller 150. The voltage generator 140 may receive an input voltage from an external device of the display device DD and generate voltages by regulating the received voltage.

The voltage generator 140 may generate a first power voltage and a second power voltage. The generated first and second power voltages may be provided to the sub-pixels SP through power lines PL. In other embodiments, at least one of the first and second power voltages may be provided from an external device to the display device DD.

In addition, the voltage generator 140 may provide various voltages and/or signals. For example, the voltage generator 140 may provide one or more initialization voltages to be applied to the sub-pixels SP. For example, during a sensing operation for sensing electrical characteristics of transistors and/or light emitting elements of the sub-pixels SP, a given reference voltage may be applied to each of the first to n-th data lines DL1 to DLn. The voltage generator 140 may generate the reference voltage and transmit the reference voltage to the data driver 130. For example, during a display operation for displaying an image on the display panel DP, common pixel control signals may be applied to the sub-pixels SP, and the voltage generator 140 may generate the pixel control signals. In embodiments, the voltage generator 140 may provide pixel control signals to the sub-pixels SP through pixel control lines PXCL. Although in FIG. 1 there is illustrated the case where the pixel control lines PXCL are connected between the voltage generator 140 and the display panel DP, the embodiments are not limited thereto. For example, the pixel control lines PXCL may be connected between the gate driver 120 and the display panel DP. In this case, the pixel control signals may be transmitted from the voltage generator 140 to the pixel control lines PXCL through the gate driver 120.

The controller 150 may control overall operations of the display device DD. The controller 150 may receive input image data IMG and a control signal CTRL corresponding thereto from an external device. The controller 150 may provide a gate control signal GCS, a data control signal DCS, and a voltage control signal VCS, in response to the control signal CTRL.

The controller 150 may convert the input image data IMG to be suitable for the display device DD or the display panel DP and output image data DATA. In embodiments, the controller 150 may align the input image data IMG to be suitable for the sub-pixels SP on a row basis and output the image data DATA.

Two or more components of the data driver 130, the voltage generator 140, and the controller 150 may be mounted on a single integrated circuit. As illustrated in FIG. 1, the data driver 130, the voltage generator 140, and the controller 150 may be included in a driver integrated circuit DIC. In this case, the data driver 130, the voltage generator 140, and the controller 150 may be components that are functionally separated from each other in the single driver integrated circuit DIC. In other embodiments, at least one of the data driver 130, the voltage generator 140, and the controller 150 may be provided as a component separated from the driver integrated circuit DIC.

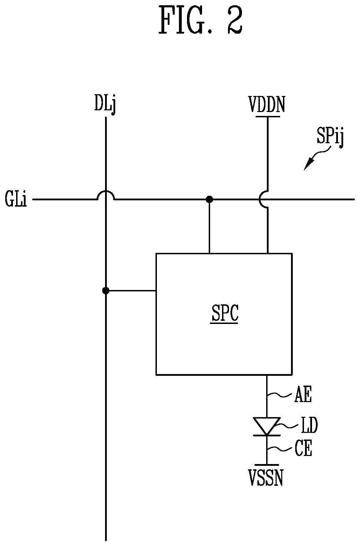

FIG. 2 is a block diagram illustrating an embodiment of any one of the sub-pixels SP of FIG. 1. In FIG. 2, there is illustrated a sub-pixel SPij disposed on an i-th row (where i is an integer identical to or greater than 1 and identical to or less than m) and a j-th column (where j is an integer identical to or greater than 1 and identical to or less than n) among the sub-pixels SP of FIG. 1.

Referring to FIG. 2, the sub-pixel SPij may include a sub-pixel circuit SPC and a light emitting element LD.

The light emitting element LD is connected between a first power voltage node VDDN and a second power voltage node VSSN. The first power voltage node VDDN may be connected to one of the power lines PL of FIG. 1 to receive a first power voltage. The second power voltage node VSSN may be connected to another one of the power lines PL of FIG. 1 to receive a second power voltage. The first power voltage may have a voltage level higher than the second power voltage.

The light emitting element LD may be connected between an anode electrode AE and a cathode electrode CE. The anode electrode AE may be connected to the first power voltage node VDDN through the sub-pixel circuit SPC. For example, the anode electrode AE may be connected to the first power voltage node VDDN through one or more transistors included in the sub-pixel circuit SPC. The cathode electrode CE may be connected to the second power voltage node VSSN. The light emitting element LD is configured to emit light based on current flowing from the anode electrode AE to the cathode electrode CE.

The sub-pixel circuit SPC may be connected both to an i-gate line GLi among the first to m-th gate lines GL1 to GLm of FIG. 1 and to a j-th data line DLj among the first to n-th data lines DL1 to DLn of FIG. 1. In response to a gate signal received through the i-th gate line GLi, the sub-pixel circuit SPC may control the light emitting element LD to emit light based on a data signal received through the j-th data line DLj. In embodiments, the sub-pixel circuit SPC may be further connected to the pixel control lines PXCL of FIG. 1. In this case, the sub-pixel circuit SPC may further control the light emitting element LD in response to pixel control signals received through the pixel control lines PXCL.

For the sake of the aforementioned operations, the sub-pixel circuit SPC may include circuit elements, for example, transistors and one or more capacitors.

The transistors of the sub-pixel circuit SPC may include p-type transistors and/or N-type transistors. In embodiments, the transistors of the sub-pixel circuit SPC may include a metal oxide silicon field effect transistor (MOSFET). In embodiments, the transistors of the sub-pixel circuit SPC may include an amorphous silicon semiconductor, a monocrystalline silicon semiconductor, a polycrystalline silicon semiconductor, an oxide semiconductor, or the like within the scope of the disclosure.

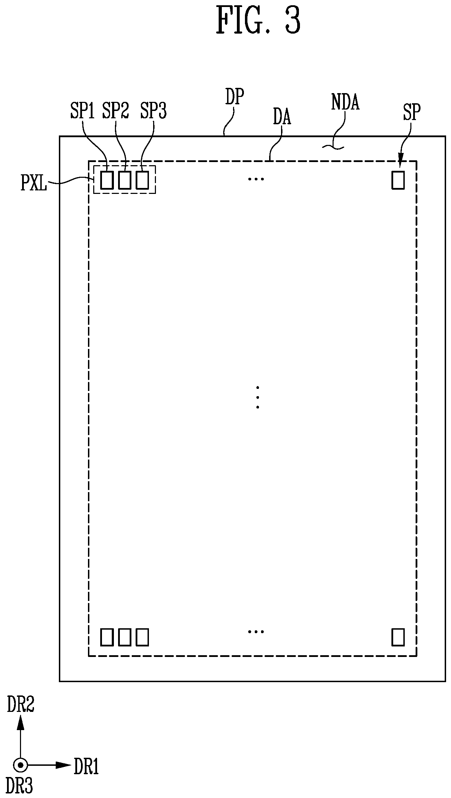

FIG. 3 is a schematic plan view illustrating an embodiment of the display panel DP of FIG. 1.

Referring to FIG. 3, the display panel DP may include a display area DA and a non-display area NDA. The display panel DP may display an image through the display area DA. The non-display area NDA may be disposed around the display area DA.

The display panel DP may include sub-pixels SP in the display area DA. The sub-pixels SP may be arranged (or disposed) in a first direction DR1 and a second direction DR2 intersecting with the first direction DR1. For example, the sub-pixels SP may be arranged (or disposed) in the form of a matrix in the first direction DR1 and the second direction DR2. As another example, the sub-pixels SP may be arranged (or disposed) in a zigzag form in the first direction DR1 and the second direction DR2. The arrangement of the sub-pixels SP may be changed depending on the embodiments. The first direction DR1 may refer to a row direction, and the second direction DR2 may refer to a column direction.

Two or more sub-pixels among the sub-pixels SP may form one pixel PXL. Although FIG. 3 illustrates that the pixel PXL may include three sub-pixels SP1 to SP3, the embodiments are not limited thereto. For example, the pixel PXL may include two sub-pixels. Hereinafter, for convenience of explanation, it is assumed that the pixel PXL may include first to third sub-pixels SP1 to SP3.

Each of the first to third sub-pixels SP1 to SP3 may generate light of one among various colors such as red, green blue, cyan, magenta, and yellow. Hereinafter, for clear and concise description, it is assumed that the first sub-pixel SP1 is configured to generate light in red, the second color pixel SP2 is configured to generate light in green, and the third sub-pixel SP3 is configured to generate light in blue.

Each of the first to third sub-pixels SP1 to SP3 may include at least one light emitting element configured to generate light. In embodiments, the light emitting elements of the first to third sub-pixels SP1 to SP3 may generate light in the same color. For example, the light emitting elements of the first to third sub-pixels SP1 to SP3 may generate light in blue. In other embodiments, the light emitting elements of the first to third sub-pixels SP1 to SP3 may generate light in different colors. For example, the light emitting elements of the first to third sub-pixels SP1 to SP3 may respectively generate light in red, green, and blue.

As a display panel DP, a self-luminous display panel such as an LED display panel using a micro-scale or nano-scale light emitting diode as a light emitting element, and an organic light emitting display panel (OLED panel) using an organic light emitting diode as a light emitting element may be used.

Components for controlling the sub-pixels SP may be disposed in the non-display area NDA. Lines connected to the sub-pixels SP, for example, the first to m-th gate lines GL1 to GLm, the first to n-th data lines DL1 to DLn, the power lines PL, and the pixel control lines PXCL of FIG. 1, may be disposed in the non-display area NDA.

At least one of the gate driver 120, the data driver 130, the voltage generator 140, and the controller 150 of FIG. 1 may be disposed in the non-display area NDA of the display panel DP. In embodiments, the gate driver 120 may be disposed in the non-display area NDA. In this case, the data driver 130, the voltage generator 140, and the controller 150 may be implemented as the driver integrated circuit DIC of FIG. 1 that is separated from the display panel DP. The driver integrated circuit DIC may be connected to the lines disposed in the non-display area NDA. In other embodiments, the gate driver 120 along with the data driver 130, the voltage generator 140, and the controller 150 may be implemented as a single integrated circuit that is separated from the display panel DP.

In embodiments, the display area DA may have various shapes. The display area DA may have a closed-loop shape, including linear and/or curved sides. For example, the display area DA may have shapes such as polygons, circles, semicircles, ellipses, and the like within the scope of the disclosure.

In embodiments, the display panel DP may have a planar display surface. In embodiments, the display panel DP may have a display surface that is least partially rounded. In embodiments, the display panel DP is bendable, foldable, or rollable. In the aforementioned cases, the display panel DP and/or a substrate of the display panel DP may include materials having flexible properties.

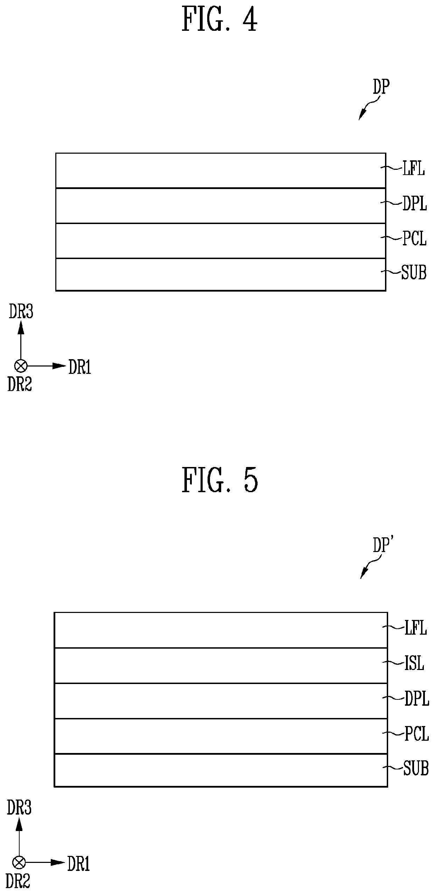

FIG. 4 is a schematic sectional view illustrating an embodiment of the display panel of FIG. 3.

Referring to FIG. 4, the display panel DP may include a substrate SUB, and a pixel circuit layer PCL, a display element layer DPL, and a light functional layer LFL that are sequentially stacked on the substrate SUB in a third direction DR3 intersecting with the first and second directions DR1 and DR2.

The substrate SUB may be made of insulating material such as glass or resin. For example, the substrate SUB may include a glass substrate. As another example, the substrate SUB may include a polyimide (PI) substrate. As another example, the substrate SUB may include a silicon wafer substrate formed through a semiconductor process.

In embodiments, the substrate SUB may be made of material having flexibility so as to be bendable or foldable, and may have a single-layer structure or a multilayer structure. For instance, the material having flexibility may include at least one of the following: polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and cellulose acetate propionate. However, the embodiments are not limited to the aforementioned example.

The pixel circuit layer PCL may be disposed on the substrate SUB. The pixel circuit layer PCL may include insulating layers, and semiconductor patterns and conductive patterns disposed between the insulating layers. The conductive patterns of the pixel circuit layer PCL may function as circuit elements, lines, or the like within the scope of the disclosure.

The circuit elements of the pixel circuit layer PCL may include the respective sub-pixel circuits SPC (refer to FIG. 2) of the sub-pixels SP of FIG. 3. In other words, the circuit elements of the pixel circuit layer PCL may be provided as transistors and one or more capacitors of the sub-pixel circuit SPC.

The lines of the pixel circuit layer PCL may include lines connected to the sub-pixels SP. The lines of the pixel circuit layer PCL may include various signal lines and/or voltage lines needed to drive the display element layer DPL.

The display element layer DPL may be disposed on the pixel circuit layer PCL. The display element layer DPL may include light emitting elements of the sub-pixels SP.

The light functional layer LFL may be disposed on the display element layer DPL. The light functional layer LFL may include light conversion patterns having color conversion particles and/or scattering particles. For example, the color conversion particles may include quantum dots. The quantum dots may convert the wavelength (or color) of light emitted from the display element layer DPL. The light functional layer LFL may further include light scattering patterns having scattering particles. In embodiments, the light conversion patterns and the light scattering patterns may be omitted.

The light functional layer LFL may further include a color filter layer including color filters. Each of the color filters may selectively transmit light of a specific wavelength (or specific color). In embodiments, the color filter layer may be omitted.

A window may be provided on the light functional layer LFL to protect an exposed surface (or upper surface) of the display panel DP. The window may protect the display panel DP from an external impact. The window may be connected to the light functional layer LFL by an optically transparent adhesive (or bonding) agent. The window may have a multilayer structure selected from among a glass substrate, a plastic film, and a plastic substrate. The multilayer structure may be formed through a successive process or an adhesion process using an adhesive layer. The entirety or portion of the window may have flexibility.

FIG. 5 is a schematic sectional view illustrating an embodiment of the display panel of FIG. 3.

Referring to FIG. 5, the display panel DP' may include a substrate SUB, a pixel circuit layer PCL, a display element layer DPL, an input sensing layer ISL, and a light functional layer LFL. The substrate SUB, the pixel circuit layer PCL, the display element layer DPL, and the light functional layer LFL may be configured in the same manner as the substrate SUB, the pixel circuit layer PCL, the display element layer DPL, and the light functional layer LFL that have been described with reference to FIG. 4. Hereinafter, repetitive explanations may be omitted.

The input sensing layer ISL may sense a user input on an upper surface (or display surface) of the display panel DP'. The input sensing layer ISL may include components suitable for sensing an external object such as the hand of the user, a pen, or the like within the scope of the disclosure. For example, the input sensing layer ISL may include touch electrodes.

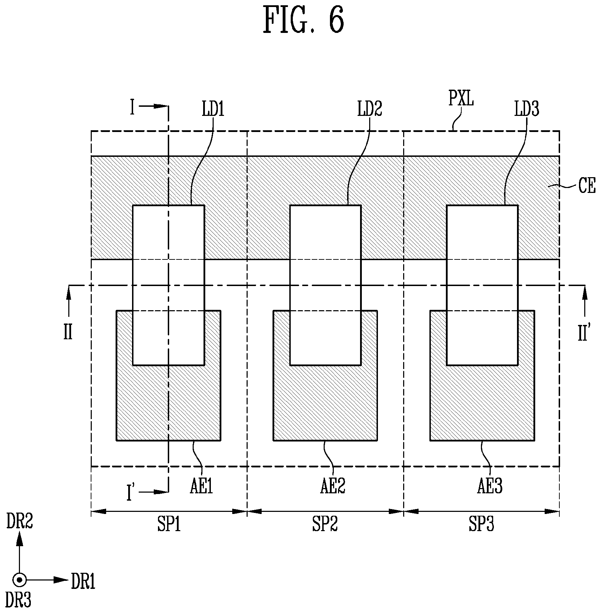

FIG. 6 is a schematic plan view illustrating an embodiment of any one of the pixels of FIG. 3.

Referring to FIG. 6, the pixel PXL may include first to third sub-pixels SP1 to SP3. The first to third sub-pixels SP1 to SP3 may be arranged (or disposed) in the first direction DR1. However, the arrangement of the pixel PXL is not limited thereto, and may be changed in various ways depending on the embodiments. For example, the first to third sub-pixels SP1 to SP3 may be arranged (or disposed) in a zigzag pattern.

First to third anode electrodes AE1 to AE3 may be respectively disposed in the first to third sub-pixels SP1 to SP3. The first anode electrode AE1 may be provided as an anode electrode AE (refer to FIG. 2) connected to the sub-pixel circuit SPC (refer to FIG. 2) of the first sub-pixel SP1. The second anode electrode AE2 may be provided as an anode electrode AE connected to the sub-pixel circuit SPC of the second sub-pixel SP2. The third anode electrode AE3 may be provided as an anode electrode AE connected to the sub-pixel circuit SPC of the third sub-pixel SP3.

The cathode electrode CE may be spaced apart from the first to third anode electrodes AE1 to AE3. The cathode electrode CE may be disposed at the same height as the first to third anode electrodes AE1 to AE3. The cathode electrode CE may be spaced apart from the first to third anode electrodes AE1 to AE3 in the second direction DR2. In embodiments, the cathode electrode CE may extend in the first direction DR1, and may be used as a common electrode for the pixel PXL and other pixels adjacent to the pixel PXL. Although not illustrated, in embodiments, the cathode electrode CE may extend not only in the first direction DR1 but also in the second direction DR2, and may thus be used as a common electrode for all of the sub-pixels SP of FIG. 3. As such, the cathode electrode CE may have various shapes.

The first to third light emitting elements LD1 to LD3 may be disposed on the first to third anode electrodes AE1 to AE3 and the cathode electrode CE. The first light emitting element LD1 may be electrically connected to the first anode electrode AE1 and the cathode electrode CE. The first light emitting element LD1 may be provided as a light emitting element LD (refer to FIG. 2) connected to the sub-pixel circuit SPC of the first sub-pixel SP1. The second light emitting element LD2 may be electrically connected to the second anode electrode AE2 and the cathode electrode CE. The second light emitting element LD2 may be provided as a light emitting element LD connected to the sub-pixel circuit SPC of the second sub-pixel SP2. The third light emitting element LD3 may be electrically connected to the third anode electrode AE3 and the cathode electrode CE. The third light emitting element LD3 may be provided as a light emitting element LD connected to the sub-pixel circuit SPC of the third sub-pixel SP3.

The first light emitting element LD1, the second light emitting element LD2, and the third light emitting element LD3 may be inorganic light emitting diodes including inorganic light emitting material. However, the embodiments are not limited to the aforementioned example and, for example, organic light emitting diodes may be used.

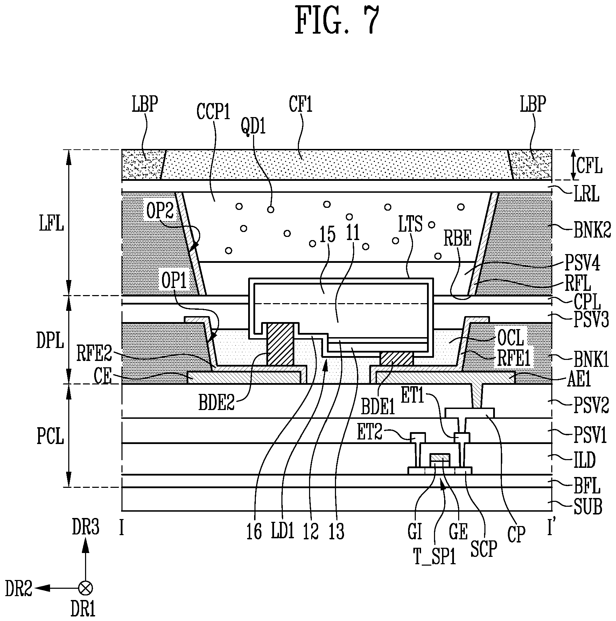

FIG. 7 is a schematic sectional view taken along line I-I' of FIG. 6.

Referring to FIGS. 6 and 7, the pixel circuit layer PCL, the display element layer DPL, and the light functional layer LFL may be sequentially disposed on the substrate SUB.

The pixel circuit layer PCL may include insulating layers, semiconductor patterns, and conductive patterns that are stacked on the substrate SUB. The insulating layers may include a buffer layer BFL, one or more interlayer insulating layers ILD, and one or more passivation layers PSV1 and PSV2. The semiconductor patterns and the conductive patterns may be positioned between the insulating layers. The conductive patterns may include at least one material of copper (Cu), molybdenum (Mo), tungsten (W), aluminum-neodymium (AINd), titanium (Ti), aluminum (Al), and silver (Ag).

As described with reference to FIG. 2, the sub-pixel circuit SPC (refer to FIG. 2) of each of the first to third sub-pixels SP1 to SP3 may include transistors and one or more capacitors. The semiconductor patterns and the conductive patterns included in the pixel circuit layer PCL may function as the transistors and the capacitors of the sub-pixel circuit SPC. Furthermore, the conductive patterns of the pixel circuit layer PCL may also function as lines, for example, the first to m-th gate lines GL1 to GLm, the first to n-th data lines DL1 to DLn, the power lines PL, and the pixel control lines PXCL of FIG. 1.

The buffer layer BFL may be disposed on one surface or a surface of the substrate SUB. The buffer layer BFL may prevent impurities from diffusing into the circuit elements and the lines that are included in the pixel circuit layer PCL. The buffer layer BFL may include an inorganic insulating layer including inorganic material. In embodiments, the buffer layer BFL may include at least one of silicon nitride (SiNₓ), silicon oxide (SiOₓ), silicon oxynitride (SiOₓN_{y}), and metal oxide such as aluminum oxide (AlOₓ). The buffer layer BF may be provided in the form of a single layer or multiple layers. In case that the buffer layer BFL is provided in the form of a multilayer structure, the respective layers may be formed of a same material or different materials.

In embodiments, one or more barrier layers may be disposed between the substrate SUB and the buffer layer BFL. Each of the barrier layers may include polyimide.

A transistor T_SP1 may be disposed on the buffer layer BFL. The first transistor T_SP1 may be any one of the transistors of the sub-pixel circuit SPC included in the first sub-pixel SP1. For example, it can be understood that the first transistor T_SP1 is a transistor connected to the first anode electrode AE1 among the transistors of the sub-pixel circuit SPC.

The transistor T_SP1 may include a semiconductor pattern SCP, a gate electrode GE, a first terminal ET1, and a second terminal ET2. The first terminal ET1 may be either a source electrode or a drain electrode, and the second terminal ET2 may be the other one of the source electrode and the drain electrode. For example, the first terminal ET1 may be a source electrode, and the second terminal ET2 may be a drain electrode.

The semiconductor pattern SCP may be disposed on the buffer layer BFL. The semiconductor pattern SCP may include a first contact area that contacts the first terminal ET1, and a second contact area that contacts the second terminal ET2. An area between the first contact area and the second contact area may be a channel area. The channel area may overlap the gate electrode GE of the transistor T_SP1. The channel area may be an undoped semiconductor pattern, and may be an intrinsic semiconductor. Each of the first contact area and the second contact area may be a semiconductor pattern doped with an impurity. For example, a p-type impurity may be used as the impurity, but the embodiments are not limited thereto.

The semiconductor pattern SCP may include any one of various types of semiconductors, for example, an amorphous silicon semiconductor, a monocrystalline silicon semiconductor, a polycrystalline silicon semiconductor, a low temperature poly silicon semiconductor, and an oxide semiconductor.

The interlayer insulating layers ILD that are sequentially stacked may be disposed on the semiconductor pattern SCP. The interlayer insulating layers ILD may be formed of inorganic insulating layers including inorganic material. For example, each of the interlayer insulating layers ILD may include at least one of silicon nitride (SiNₓ), silicon oxide (SiOₓ), silicon oxynitride (SiOₓN_{y}), and metal oxide such as aluminum oxide (AlOₓ). However, the material of the interlayer insulating layers ILD is not limited to the aforementioned examples. For example, any one of the interlayer insulating layers ILD may include an organic insulating layer including organic material.

The interlayer insulating layers ILD may electrically separate the conductive patterns and/or semiconductor patterns that are disposed between the interlayer insulating layers ILD from each other. For example, the interlayer insulating layers ILD may include a gate insulating layer GI disposed on the semiconductor pattern SCP. The gate insulating layer GI may be disposed between the semiconductor pattern SCP and the gate electrode GE such that the gate electrode GE is spaced apart from the semiconductor pattern SCP. In embodiments, the gate insulating layer GI may be disposed on the overall surfaces of the semiconductor pattern SCP and the buffer layer BFL, thus covering the semiconductor pattern SCP and the buffer layer BFL. As the number of layers needed to form the conductive patterns and/or the semiconductor patterns increases, the number of interlayer insulating layers ILD may increase.

The gate electrode GE may be disposed on the gate insulating layer GI. The gate electrode GE may overlap the channel area of the semiconductor pattern SCP. In embodiments, the gate electrode GE may be provided in the form of a single layer including at least one material of copper (Cu), molybdenum (Mo), tungsten (W), aluminum-neodymium (AINd), titanium (Ti), aluminum (Al), and silver (Ag). In embodiments, the gate electrode GE may be provided in the form of a multilayer structure including at least one material of molybdenum (Mo), titanium (Ti), aluminum (Al), and silver (Ag) that are low-resistance materials.

The first and second terminals ET1 and ET2 may be disposed on the interlayer insulating layers ILD. The first and second terminals ET1 and ET2 may contact the semiconductor pattern SCP through contact holes passing through the interlayer insulating layers ILD. The first and second terminals ET1 and ET2 may respectively contact the first and second contact areas of the semiconductor pattern SCP. Each of the first and second terminals ET1 and ET2 may include at least one material of copper (Cu), molybdenum (Mo), tungsten (W), aluminum-neodymium (AINd), titanium (Ti), copper (Cu), aluminum (Al), and silver (Ag).

Although the first and second terminals ET1 and ET2 are illustrated as separate electrodes electrically connected to the semiconductor pattern SCP, the embodiments are not limited thereto. In embodiments, the first terminal ET1 may be a first contact area adjacent to one side or a side of the channel area of the semiconductor pattern SCP, and the second terminal ET2 may be a second contact area adjacent to the other side of the channel area. In this case, the first terminal ET1 may be electrically connected to the light emitting element LD through a connector such as a bridge electrode disposed on at least one of the interlayer insulating layers ILD.

In embodiments, the transistor T_SP1 may be formed of a low-temperature polysilicon transistor. However, the embodiments are not limited to the aforementioned example. For example, the transistor T_SP1 may be formed of an oxide semiconductor transistor. In embodiments, the sub-pixel circuit of the first sub-pixel SP1 may include different types of transistors. For example, the transistor T_SP1 may be formed of a low-temperature polysilicon transistor. The other transistors of the first sub-pixel SP1 may be formed of oxide semiconductor transistors. In this case, an oxide semiconductor of the corresponding oxide semiconductor transistor may be disposed on any one of the interlayer insulating layers ILD rather than on an insulating layer on which the semiconductor pattern SCP of the transistor T_SP1 is disposed.

Although in the embodiments the case where the transistor T_SP1 has a top gate structure has been described as an example, the embodiments are not limited thereto. For example, the transistor T_SP1 may be a transistor having a bottom gate structure. In addition, the structure of the transistor T_SP1 may be changed in various ways.

At least some of the various lines for the display panel DP and/or the display device DD may be further disposed on the interlayer insulating layers ILD.

A first passivation layer PSV1 may be disposed on the interlayer insulating layers ILD and the first and second terminals ET1 and ET2. The passivation layer may be referred to as a protective layer or a via layer. The first passivation layer PSV1 may protect components disposed thereunder and provide an even upper surface.

A connection pattern CP may be disposed on the first passivation layer PSV1. The connection pattern CP may pass through the first passivation layer PSV1 and be connected to the first terminal ET1 of the transistor T_SP1. The connection pattern CP may include at least one material of copper (Cu), molybdenum (Mo), tungsten (W), aluminum-neodymium (AINd), titanium (Ti), aluminum (Al), and silver (Ag).

At least some of the various lines for the display panel DP and/or the display device DD may be further disposed on the first passivation layer PSV1.

A second passivation layer PSV2 may be disposed on the connection pattern CP and the first passivation layer PSV1. The second passivation layer PSV2 may protect components disposed thereunder and provide an even upper surface.

Each of the first and second passivation layers PSV1 and PSV2 may include an inorganic insulating layer including inorganic material, and/or an organic insulating layer including organic material. The inorganic insulating layer may include, for example, at least one of silicon oxide (SiOₓ), silicon nitride (SiNₓ), silicon oxynitride (SiOₓN_{y}), and metal oxide such as aluminum oxide (AlOₓ). The organic insulating layer may include, for example, at least one of acrylic resin, epoxy resin, phenol resin, polyamide resin, polyimide rein, unsaturated polyester resin, polyphenylen ether resin, poly-phenylene sulfide resin, and benzocyclobutene resin.

The first and second passivation layers PSV1 and PSV2 may include a same material as any one of the interlayer insulating layers ILD, but the embodiments are not limited thereto. Each of the first and second passivation layers PSV1 and PSV2 may be provided in the form of a single-layer structure, but may be provided in the form of a multilayer structure.

The display element layer DPL may be disposed on the second passivation layer PAS2. The display element layer DPL may include the first anode electrode AE1, the cathode electrode CE, a first bank BNK1, first and second reflective electrodes RFE1 and RFE2, the first light emitting element LD1, an overcoat layer OCL, a third passivation layer PSV3, and a capping layer CPL.

The first anode electrode AE1 and the cathode electrode CE may be disposed on the pixel circuit layer PCL.

The first anode electrode AE1 may be electrically connected to a connection electrode CP through a contact hole passing through the second passivation layer PSV2. As such, the first anode electrode AE1 may be electrically connected to the first transistor T_SP1.

The cathode electrode CE may be spaced apart from the first anode electrode AE1 in the first direction DR1. The cathode electrode CE may be electrically connected to the second power voltage node VSSN of FIG. 2. Accordingly, a second power voltage applied to the second power voltage node VSSN may be transmitted to the cathode electrode CE.

The first bank BNK1 may be disposed on the first anode electrode AE1 and the cathode electrode CE. The first bank BNK1 may include a first opening OP1 through which portions of the first anode electrode AE1 and the cathode electrode CE are exposed. The first light emitting element LD1 may be disposed in the first opening OP1 of the first bank BNK1. As such, the first bank BNK1 may be provided as a pixel defining layer that defines an area where the first light emitting element LD1 is positioned.

The first bank BNK1 may include light blocking material to prevent light mixture between adjacent sub-pixels. In embodiments, the first bank BNK1 may include organic material. For example, the first bank BNK1 may include organic insulating material made of material such as acryl resin, epoxy resin, phenol resin, polyamide resin, polyimide resin, or the like within the scope of the disclosure.

The first reflective electrode RFE1 may be disposed on the exposed portion of the first anode electrode AE1 and a side surface of the first bank BNK1 adjacent thereto. The second reflective electrode RFE2 may be disposed on the exposed portion of the cathode electrode CE and a side surface of the first bank BNK1 adjacent thereto. The first and second reflective electrodes RRE1 to RRE2 may include conductive materials suitable for reflecting light. Consequently, the light output efficiency of the first light emitting element LD1 may be enhanced. In embodiments, the first and second reflective electrodes RFE1 and RFE2 may include at least one of aluminum (Al), silver (Ag), magnesium (Mg), platinum (Pt), palladium (Pd), gold (Au), nickel (Ni), neodymium (Nd), iridium (Ir), chromium (Cr), titanium (Ti), and an alloy of two or more materials selected from among the aforementioned materials. However, the embodiments are not limited to the aforementioned example.

The first light emitting element LD1 may be electrically connected to the first anode electrode AE1 through the first reflective electrode RFE1. The first light emitting element LD1 may be electrically connected to the cathode electrode CE through the second reflective electrode RFE2. The first light emitting element LD1 may be bonded to the first and second reflective electrodes RFE1 and RFE2.

The first light emitting element LD1 may include a first semiconductor layer 11, an active layer 12, a second semiconductor layer 13, and an auxiliary layer 15. The first light emitting element LD1 may include an emission stack in which the auxiliary layer 15, the first semiconductor layer 11, the active layer 12, and the second semiconductor layer 13 are sequentially stacked.

The first light emitting element LD1 may include first and second bonding electrodes BDE1 and BDE2 oriented in the same direction (for example, in a direction opposite to the third direction DR3). The first bonding electrode BDE1 may be connected to the second semiconductor layer 13. The second bonding electrode BDE2 may be connected to the first semiconductor layer 11 exposed by etching the second semiconductor layer 13 and the active layer 12. The first light emitting element LD1 may be a flip-chip-type light emitting element.

The first semiconductor layer 11 may be configured to provide electrons to the active layer 12. The first semiconductor layer 11 may include, for example, at least one n-type semiconductor layer. For example, the first semiconductor layer 11 may include any one semiconductor material among gallium nitride (GaN), aluminum gallium nitride (AlGaN), indium gallium nitride (InGaN), and aluminum nitride (AIN), and may be an n-type semiconductor layer doped with a first conductive dopant (or n-type dopant) such as silicon (Si), germanium (Ge), or tin (Sn). However, the material for forming the first semiconductor layer 11 is not limited to the aforementioned example, and various other materials may be used to form the first semiconductor layer 11. In an embodiment, the first semiconductor layer 11 may include gallium nitride (GaN) semiconductor material doped with a first conductive dopant (or an n-type dopant). In an embodiment, the first semiconductor layer 11 along with the auxiliary layer 15 may form an n-type semiconductor layer.

The active layer 12 may be disposed on the first semiconductor layer 11, and may be an area where electrons and holes are recombined with each other. As electrons and holes are recombined with each other in the active layer 12, the electrons and holes make a transition to a low energy level, whereby light having a corresponding wavelength may be generated. The active layer 12 may have a single or multi-quantum well structure. In case that the active layer 12 is formed to have a multi-quantum well structure, units each including a barrier layer, a stain reinforcing layer, and a well layer may be repeatedly stacked to form the active layer 12. However, embodiments of the active layer 12 are not limited to the aforementioned example.

The second semiconductor layer 13 may be disposed on the active layer 12, and may provide holes to the active layer 12. The second semiconductor layer 13 may include a semiconductor layer of a type different from the first semiconductor layer 11. For example, the second semiconductor layer 13 may include at least one p-type semiconductor layer. For example, the second semiconductor layer 13 may include at least one semiconductor material among gallium nitride (GaN), aluminum gallium nitride (AlGaN), indium gallium nitride (InGaN), aluminum nitride (AIN), and indium nitride (InN), and may be a p-type semiconductor layer doped with a second conductive dopant (or p-type dopant) such as magnesium (Mg), zinc (Zn), calcium (Ca), strontium (Sr), barium (Ba), or the like within the scope of the disclosure. However, the material for forming the second semiconductor layer 13 is not limited to the aforementioned example, and various other materials may be used to form the second semiconductor layer 13. In an embodiment, the second semiconductor layer 13 may include gallium nitride (GaN) semiconductor material doped with a second conductive dopant (or a p-type dopant).

The auxiliary layer 15 may include undoped gallium nitride (GaN) semiconductor material, and may form an n-type semiconductor layer along with the first semiconductor layer 11.

The first bonding electrode BDE1 may be electrically connected to the second semiconductor layer 13. The second bonding electrode BDE2 may be electrically connected to the first semiconductor layer 11. The first and second bonding electrodes BDE1 and BDE2 may include eutectic metal.

The first light emitting element LD1 may further include an insulating layer 16 provided to cover a circumferential outer surface of the emission stack. The insulating layer 16 may prevent the active layer 12 from short-circuiting due to contact with other conductive material other than the first and second semiconductor layers 11 and 13. The insulating layer 16 may include transparent insulating material. The insulating layer 16 is configured such that lower surfaces of the first and second bonding electrodes BDE1 and BDE2 are exposed.

The lower surface of the first bonding electrode BDE1 contacts the first reflective electrode RFE1. Accordingly, the first bonding electrode BDE1 may be electrically connected to the first anode electrode AE1 through the first reflective electrode RFE1. The lower surface of the second bonding electrode BDE2 contacts the second reflective electrode RFE2. Accordingly, the second bonding electrode BDE2 may be electrically connected to the cathode electrode CE through the second reflective electrode RFE2.

The overcoat layer OCL may be disposed in the first opening OP1 in which the first and second reflective electrodes RFE1 and RFE2 and the first light emitting element LD1 are disposed. The overcoat layer OCL may secure the first light emitting element LD1 bonded to the first and second reflective electrodes RFE1 and RFE2 in place so as to prevent movement. Furthermore, the overcoat layer OCL may protect components disposed thereunder from foreign substances such as dust and water. For example, the overcoat layer OCL may include at least one of an inorganic insulating layer and an organic insulating layer. For example, the overcoat layer OCL may include epoxy, but the embodiments are not limited thereto.

The third passivation layer PSV3 may be disposed on the first bank BNK1 and the overcoat layer OCL. The third passivation layer PSV3 may protect components disposed thereunder and provide an even upper surface. The third passivation layers PSV3 may include a same material as any one of the first and second passivation layers PSV1 and PSV2, but the embodiments are not limited thereto.

In embodiments, the third passivation layer PSV3 may not be disposed on an upper surface LTS of the first light emitting element LD1. The first light emitting element LD1 may protrude into the light functional layer LFL. The first light emitting element LD1 may be positioned at least partially in a second opening OP2 of a second bank BNK2. For example, a height of the upper surface LTS of the first light emitting element LD1 from the substrate SUB may be higher than that of a lowermost end RBE of a reflective layer RFL. Accordingly, light emitted from the first light emitting element LD1 may be provided to the light functional layer LFL at a relatively high rate.

The capping layer CPL may be disposed on the third passivation layer PSV3. The capping layer CPL may protect components disposed under or below the capping layer CPL such as the first light emitting element LD1 from external water, moisture, or the like within the scope of the disclosure. In embodiments, the capping layer CPL may not be disposed on the upper surface of the first light emitting element LD1. In other embodiments, the capping layer CPL may cover overall surfaces of the first light emitting element LD1 and the third passivation layer PSV3. The capping layer CPL may include at least one of silicon nitride (SiNₓ), silicon oxide (SiOₓ), silicon oxynitride (SiOₓN_{y}), and metal oxide such as aluminum oxide (AlOₓ). However, the material of the capping layer CPL may not be limited to the aforementioned example.

Hitherto, the pixel circuit layer PCL and the display element layer DPL of the first sub-pixel SP1 have been described. Each of the second and third sub-pixels SP2 and SP3 of FIG. 6 may also be configured in the same manner as the first sub-pixel SP1 unless otherwise described.

The light functional layer LFL may be disposed on the capping layer CPL. The light functional layer LFL may include the second bank BNK2, the reflective layer RFL, a fourth passivation layer PSV4, a first light conversion pattern CCP1, a low refractive layer LRL, and a color filter layer CFL.

The second bank BNK2 may be disposed on the capping layer CPL. The second bank BNK2 may overlap the first bank BNK1. The second bank BNK2 may have the second opening OP2 that overlaps the first opening OP1.

The second bank BNK2 may include light blocking material to prevent light mixture between adjacent sub-pixels. In embodiments, the second bank BNK2 may include organic material. For example, the second bank BNK2 may include organic insulating material made of material such as acryl resin, epoxy resin, phenol resin, polyamide resin, polyimide resin, or the like within the scope of the disclosure.

The reflective layer RFL may be disposed on sidewalls of the second bank BNK2 adjacent to the second opening OP2. The reflective layer RFL is configured to reflect incident light, thus enhancing the light output efficiency. The reflective layer RFL may include material suitable for reflecting light. The reflective layer RFL may include at least one of aluminum (Al), silver (Ag), magnesium (Mg), platinum (Pt), palladium (Pd), gold (Au), nickel (Ni), neodymium (Nd), iridium (Ir), chromium (Cr), titanium (Ti), and an alloy of two or more materials selected from among the aforementioned materials. However, the embodiments are not limited to the aforementioned example.

The fourth passivation layer PSV4 may be disposed on the capping layer CPL in the second opening OP2. The fourth passivation layer PSV4 may protect components disposed thereunder and provide an even upper surface. The fourth passivation layer PSV4 may include a same material as any one of the first to third passivation layers PSV1 to PSV3, but the embodiments are not limited thereto.

The first light conversion pattern CCP1 may be disposed on the fourth passivation layer PSV4 in the second opening OP2.

The first light conversion pattern CCP1 may include color conversion particles and/or scattering particles. The color conversion particles may change the wavelength of incident light and convert the incident light into light in a different color. Furthermore, the color conversion particles may scatter the incident light. In embodiments, the color conversion particles may be quantum dots. The scattering particles may scatter incident light.

The first sub-pixel SP1 may be a red sub-pixel. In the case where the first light emitting element LD1 emits light in blue, the first light conversion pattern CCP1 may include first color conversion particles QD1 configured to convert light in blue into light in red. In the case where the first light emitting element LD1 emits light in red, the first light conversion pattern CCP1 may include scattering particles. As such, particles included in the first light conversion pattern CCP1 may be changed in various ways depending on the type of the first light emitting element LD1.

The low refractive layer LRL may be disposed on the second bank BNK2, the reflective layer RFL, and the first light conversion pattern CCP1. The low refractive layer LRL may have a refractive index lower than the first light conversion pattern CCP1. The low refractive layer LRL is configured to refract or totally reflect incident light depending on an incident angle of the corresponding light. For example, the low refractive layer LRL may provide light passing through the first light conversion pattern CCP1 to the first light conversion pattern CCP1 again. Accordingly, the light conversion efficiency of the first color conversion pattern CCP1 may be improved.

The color filter layer CFL may be disposed on the low refractive layer LRL. The color filter layer CFL may include the first color filter CF1 and light blocking patterns LBP. The first color filter CF1 may overlap the first light conversion pattern CCP1. The first color filter CF1 allows light in a desired wavelength range to selectively pass therethrough. In the case where the first sub-pixel SPX1 is a red sub-pixel, the first color filter CF1 may include a red color filter. The light blocking patterns LBP may include at least one of various kinds of light blocking materials.

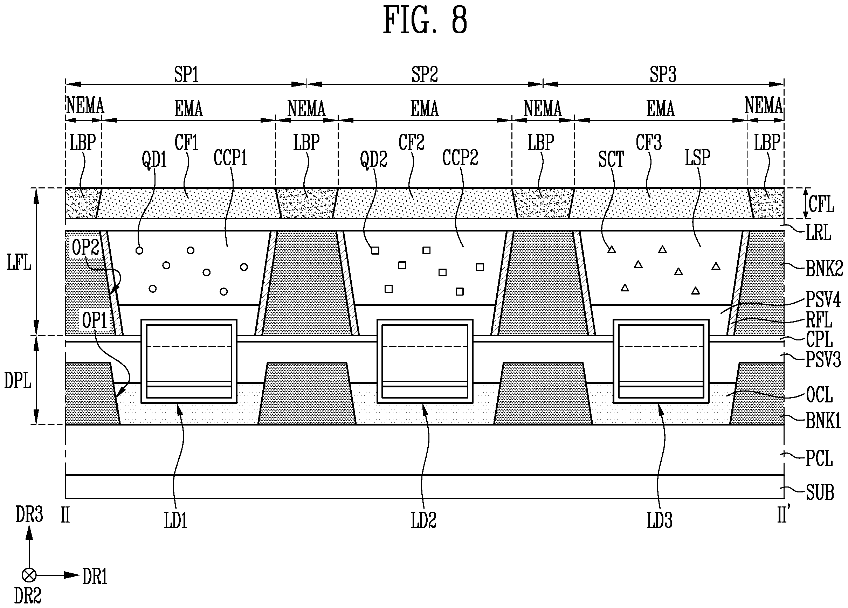

FIG. 8 is a schematic sectional view taken along line II-II' of FIG. 6.

Referring to FIGS. 6 and 8, the pixel circuit layer PCL, the display element layer DPL, and the light functional layer LFL may be sequentially disposed on the substrate SUB.

The pixel circuit layer PCL and the display element layer DPL can be described in the same manner as described with reference to FIG. 7. Sub-pixel circuits respectively corresponding to the first to third sub-pixels SP1 to SP3 may be provided in the pixel circuit layer PCL. The first to third light emitting elements LD1 to LD3 respectively corresponding to the first to third sub-pixels SP1 to SP3 may be provided in the display element layer DPL. The first to third light emitting elements LD1 to LD3 may overlap first openings OP1 of the first bank BNK1. The first light emitting elements LD1 may be connected between the cathode electrode CE (refer to FIG. 7) and the transistor T_SP1 (refer to FIG. 7) included in the sub-pixel circuit of the first sub-pixel SP1. The second light emitting element LD2 may be connected between the cathode electrode CE and the transistor included in the sub-pixel circuit of the second sub-pixel SP2. The third light emitting element LD3 may be connected between the cathode electrode CE and the transistor included in the sub-pixel circuit of the third sub-pixel SP3. Hereinafter, repetitive explanations may be omitted.

The light functional layer LFL may be provided on the display element layer DPL. The light functional layer LFL may be described in the same manner as described with reference to FIG. 7. Hereinafter, repetitive explanations may be omitted.

The second bank BNK2 may include second openings OP2. It can be understood that an emission area EMA and a non-emission area NEMA for each of the first to third sub-pixels SP1 to SP3 are defined by the second bank BNK2. An area overlapping the second bank BNK2 may correspond to the non-emission area NEMA. Areas overlapping the second openings OP2 of the second bank BNK2 may correspond to the emission areas EMA of the first to third sub-pixels SP1 to SP3.

The fourth passivation layer PSV4 may be disposed on the capping layer CPL in the second openings OP2. First and second light conversion patterns CCP1 and CCP2 and a light scattering pattern LSP may be disposed on the fourth via layer PSV4 in the second openings OP2.

In embodiments, the first to third light emitting elements LD1 to LD3 may be configured to emit light in blue. In this case, the first light conversion pattern CCP1 may include first color conversion particles QD1 configured to convert light in blue into light in red. The second light conversion pattern CCP2 may include second color conversion particles QD2 configured to convert light in blue into light in green. The light scattering pattern LSP may include scattering particles SCT for scattering light in blue to enhance the light output efficiency. Accordingly, the first to third sub-pixels SP1 to SP3 may be provided as a red sub-pixel, a green sub-pixel, and a blue sub-pixel, respectively. In embodiments, at least one of the first and second light conversion patterns CCP1 and CCP2 and the light scattering pattern LSP may further include color conversion particles provided to convert light in blue into light in white.

In embodiments, the first to third light emitting elements LD1 to LD3 may be configured to emit light in red, green, and blue, respectively. In this case, each of the first and second light conversion patterns CCP1 and CCP2 and the light scattering pattern LSP may include scattering particles SCT. As such, particles included in the first and second light conversion patterns CCP1 and CCP2 and the light scattering pattern LSP may be changed in various ways depending on the first to third light emitting elements LD1 to LD3.

In embodiments, the first and second light conversion patterns CCP1 and CCP2 and the light scattering pattern LSP may be omitted.

The low refractive layer LRL may be disposed on the second bank BNK2, the reflective layer RFL, the first and second light conversion patterns CCP1 and CCP2, and the light scattering pattern LSP. The low refractive layer LRL may have a refractive index lower than the first and second light conversion patterns CCP1 and CCP2 and the light scattering pattern LSP. In embodiments, the low refractive layer LRL may be omitted in an area corresponding to the third sub-pixel SP3.

The color filter layer CFL may be disposed on the low refractive layer LRL. The color filter layer CFL may include first to third color filters CF1 to CF3 and light blocking patterns LBP.

Each of the first to third color filters CF1 to CF3 allows light in a desired wavelength range to selectively pass therethrough. In the case where the first sub-pixel SPX1 is a red sub-pixel, the first color filter CF1 may include a red color filter. In the case where the second sub-pixel SPX2 is a green sub-pixel, the second color filter CF2 may include a green color filter. In the case where the third sub-pixel SP3 is a blue sub-pixel, the third color filter CF3 may include a blue color filter. Each of the first to third color filters CF1 to CF3 may have a refractive index higher than the low refractive layer LRL. However, the embodiments are not limited to the aforementioned example, each of the first to third color filters CF1 to CF3 may have a refractive index equal to or lower than the low refractive layer LRL.

The light blocking patterns LBP may be disposed between the first to third color filters CF1 to CF3. It can be understood that an emission area (or light output area) EMA and a non-emission area NEMA for each of the first to third sub-pixels SP1 to SP3 are defined by the light blocking patterns LBP. An area overlapping the light blocking patterns LBP may correspond to the non-emission area NEMA. An area that does not overlap the light blocking patterns LBP may correspond to the emission area EMA.

In embodiments, the light blocking patterns LBP may include at least one of various kinds of light blocking materials. In embodiments, each of the light blocking patterns LBP may be provided in the form of a multilayer structure in which at least two color filters of the first to third color filters CF1 to CF3 overlap each other. For example, each of the light blocking patterns LBP may be formed by overlapping the first to third color filters CF1 to CF3. As another example, a light blocking pattern between the first and second color filters CF1 and CF2 among the light blocking patterns LBP may be formed of a multilayer structure in which the first and second color filters CF1 and CF2 overlap each other. Furthermore, a light blocking pattern between the second and third color filters CF2 and CF3 among the light blocking patterns LBP may be formed of a multilayer structure in which the second and third color filters CF2 and CF3 overlap each other. A light blocking pattern between the first color filter CF1 and a third color filter CF3 of a neighboring pixel may be formed of a multilayer structure in which the first and third color filters CF1 and CF3 overlap each other. As such, each of the first to third color filters CF1 to CF3 may extend to the non-emission area NEMA, thus forming the light blocking patterns LBP.

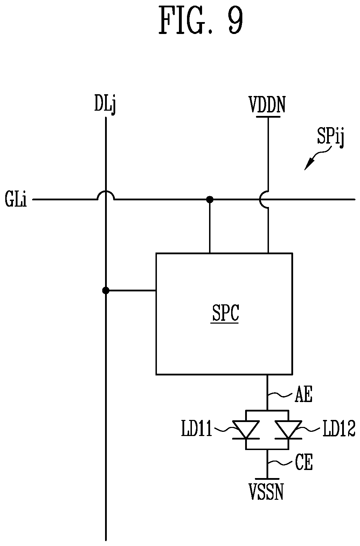

FIG. 9 is a block diagram illustrating an embodiment of any one of the sub-pixels of FIG. 1. In FIG. 9, there is illustrated a sub-pixel SPij disposed on an i-th row (where i is an integer identical to or greater than 1 and identical to or less than m) and a j-th column (where j is an integer identical to or greater than 1 and identical to or less than n) among the sub-pixels SP of FIG. 1. In the following descriptions pertaining to FIG. 9, redundant descriptions overlapping those of FIG. 2 may be omitted.

Referring to FIG. 9, the sub-pixel SPij may include a sub-pixel circuit SPC, a first light emitting element LD11, and a second light emitting element LD12.

The first light emitting element LD11 and the second light emitting element LD12 may be connected between a first power voltage node VDDN and a second power voltage node VSSN. The first light emitting element LD11 and the second light emitting element LD12 may be connected in parallel to each other.

The first light emitting element LD11 may be connected between an anode electrode AE and a cathode electrode CE. The second light emitting element LD12 may be connected between the anode electrode AE and the cathode electrode CE.

In the case where, as illustrated in FIG. 9, the sub-pixel may include the first light emitting element LD11 and the second light emitting element LD12 connected in parallel to each other, even if a defect occurs in any one of the first light emitting element LD11 and the second light emitting element LD12, the corresponding sub-pixel may display an image with the remaining normal light emitting element.

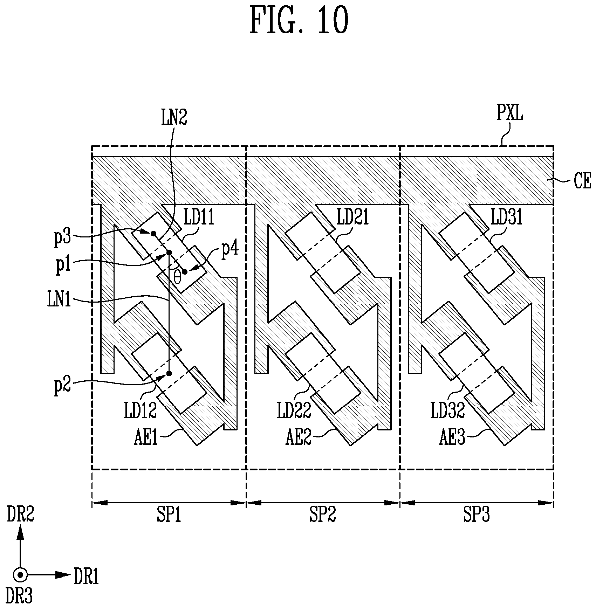

FIG. 10 is a schematic plan view illustrating a pixel PXL included in a display device in accordance with an embodiment.

Referring to FIG. 10, the pixel PXL may include first to third sub-pixels SP1 to SP3. The first to third sub-pixels SP1 to SP3 may be arranged (or disposed) in the first direction DR1. However, the arrangement of the pixel PXL is not limited thereto, and may be changed in various ways depending on the embodiments. For example, the first to third sub-pixels SP1 to SP3 may be arranged (or disposed) in a zigzag pattern.

First to third anode electrodes AE1 to AE3 may be respectively disposed in the first to third sub-pixels SP1 to SP3. The first anode electrode AE1 may be connected to first and second light emitting elements LD11 and LD12 of the first sub-pixel SP1. The second anode electrode AE2 may be connected to first and second light emitting elements LD21 and LD22 of the second sub-pixel SP2. The third anode electrode AE3 may be connected to first and second light emitting elements LD31 and LD32 of the third sub-pixel SP3.

The cathode electrode CE may be disposed at the same height as the first to third anode electrodes AE1 to AE3. The cathode electrode CE may be spaced apart from the first to third anode electrodes AE1 to AE3. In embodiments, the cathode electrode CE may extend in the first direction DR1, and may include, in each sub-pixel area, a protrusion formed in a direction opposite to the second direction DR2. The cathode electrode CE may be used as a common electrode for the pixel PXL and other pixels adjacent to the pixel PXL in a row direction. The shape of the cathode electrode CE illustrated in FIG. 10 is only for illustrative purposes, and the cathode electrode CE may have various other shapes.

Each of the first to third sub-pixels SP1 to SP3 may include two light emitting elements. As illustrated in FIG. 10, the first sub-pixel SP1 may include first and second light emitting elements LD11 and LD12. The second sub-pixel SP2 may include first and second light emitting elements LD21 and LD22. The third sub-pixel SP3 may include first and second light emitting elements LD31 and LD32.

In detail, the first and second light emitting elements LD11 and LD12 included in the first sub-pixel SP1 may be connected in parallel between the first anode electrode AE1 and the cathode electrode CE. The first and second light emitting elements LD21 and LD22 included in the second sub-pixel SP2 may be connected in parallel between the second anode electrode AE2 and the cathode electrode CE. The first and second light emitting elements LD31 and LD32 included in the third sub-pixel SP3 may be connected in parallel between the third anode electrode AE3 and the cathode electrode CE.

In the display device in accordance with an embodiment, the first and second light emitting elements included in the sub-pixel may be diagonally oriented. In detail, referring to the first sub-pixel SP1 illustrated in FIG. 10, there is illustrated a first line LN1 connecting respective centers p1 and p2 of the first and second light emitting elements LD1 and LD2 to each other. Furthermore, referring to the first sub-pixel SP1 illustrated in FIG. 10, there is illustrated a second line LN2 connecting a center p3 of an area where the first light emitting element LD1 overlaps the cathode electrode CE and a center p4 of an area where the first light emitting element LD1 overlaps the first anode electrode AE1 to each other. In the specification, the words "first and second light emitting elements are diagonally oriented" may indicate that an angle (θ) between the first line LN1 and the second line LN2 is greater than about 0° and less than about 90°.

As the first and second light emitting elements included in the sub-pixel are diagonally oriented, the surface area of the sub-pixel may be minimized, and two light emitting elements may be included in a single sub-pixel.

For example, in the case where the orientation of each of the two light emitting elements included in the sub-pixel refers to a horizontal direction, for example, in the case where the angle (θ) between the first line LN1 and the second line LN2 is about 90° in FIG. 10, the length of the sub-pixel SP1 in the first direction DR1 may increase. The foregoing structure may make it difficult to increase pixel resolution in the first direction DR1.

In the case where the orientation of each of the two light emitting elements included in the sub-pixel refers to a vertical direction, for example, in the case where the angle (θ) between the first line LN1 and the second line LN2 is 0° in FIG. 10, the length of the sub-pixel SP1 in the second direction DR2 may increase. The foregoing structure may be a reason for increasing the pixel resolution in the second direction DR2. In the case where, as shown in the embodiment of FIG. 6, each sub-pixel may include a single light emitting element, the pixel resolution in the second direction DR2 may increase regardless of the orientation of the light emitting element. However, in the case where one sub-pixel may include two light emitting elements, if the light emitting elements are oriented in the vertical direction, it is difficult to increase the pixel resolution in the second direction DR2.

In a display device in accordance with an embodiment, as illustrated in FIG. 10, the first and second light emitting elements included in the sub-pixel are diagonally oriented. Hence, the pixel resolution in the second direction DR2 may be maintained, and two light emitting elements may be included in one sub-pixel.

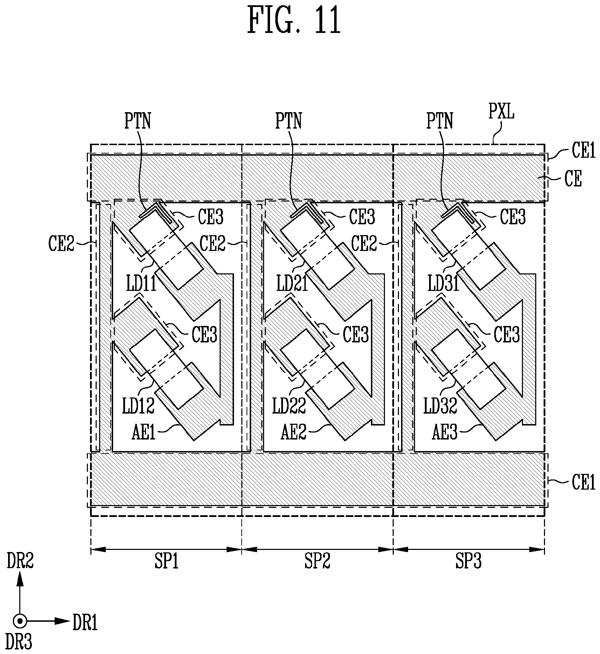

FIG. 11 is a schematic plan view illustrating a pixel included in a display device in accordance with an embodiment. In the following descriptions pertaining to FIG. 11, redundant descriptions overlapping those of FIG. 10 may be omitted.

Referring to FIG. 11, the pixel PXL may include first to third sub-pixels SP1 to SP3. First to third anode electrodes AE1 to AE3 may be respectively disposed in the first to third sub-pixels SP1 to SP3. The first to third anode electrodes AE1 to AE3 illustrated in FIG. 11 may be the same in shape as the first to third anode electrodes AE1 to AE3 illustrated in FIG. 10.

The cathode electrode CE may be disposed at the same height as the first to third anode electrodes AE1 to AE3. The cathode electrode CE illustrated in FIG. 11 may have a substantially mesh structure. In more detail, the cathode electrode CE may include first line components CE1 extending in the first direction DR1, and second line components CE2 extending in the second direction DR2. Optionally, the cathode electrode CE may further include protrusions CE3 that diagonally protrude from the first line components CE1 or the second line components CE2 toward the light emitting elements.

In an embodiment, the cathode electrode CE may include patterns PTN configured to check whether the light emitting elements are normally formed. After the cathode electrode CE and the anode electrodes AE1, AE2, and AE3 are formed, the orientation angles of the light emitting elements may be different from a desired angle due to process errors during the formation of the light emitting elements. To check foregoing process errors, the patterns PTN may be formed in advance in the cathode electrode CE. The patterns PTN may be provided as openings formed around desired positions of the light emitting elements. In other words, each of the patterns PTN may be formed in a desired shape by removing a corresponding portion of the cathode electrode CE1. Although in FIG. 11 there is illustrated an example where the patterns PTN are formed in the protrusions CE3 of the cathode electrode CE, the embodiments are not limited thereto. For example, the patterns PTN may be formed in the first line components CE1, or may be formed in the second line components CE2. As another example, the pattern PTN may be formed over at least two or more components of the first line components CE1, the second line components CE2, and the protrusions CE3.

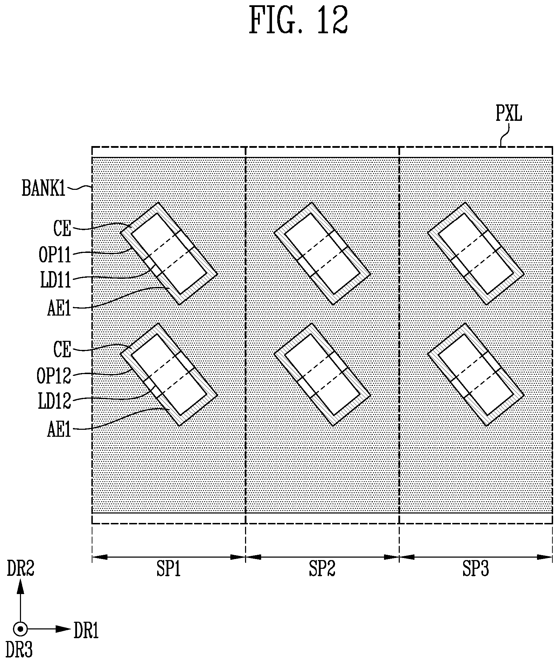

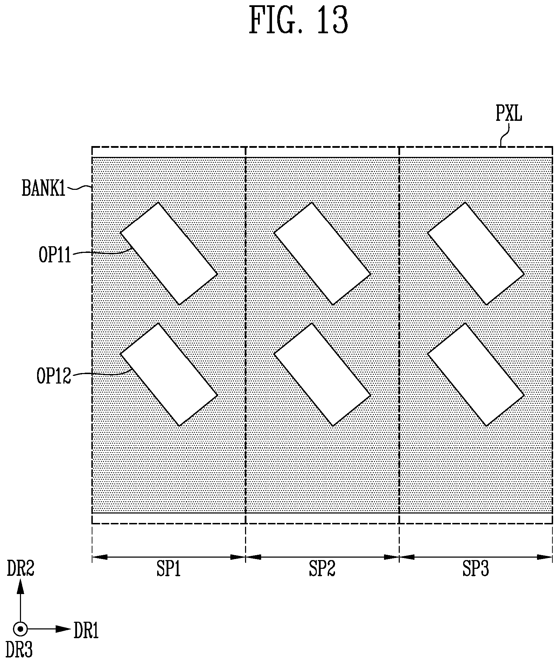

FIG. 12 is a diagram for describing a bank of the pixel illustrated in FIG. 10 or 11. FIG. 13 is a diagram illustrating only a first bank BANK1 of FIG. 12. Hereinafter, descriptions will be made with reference also to FIGS. 12 and 13.

Referring to FIG. 12, the first bank BNK1 may be disposed on the first anode electrode AE1 and the cathode electrode CE. In an area of the first sub-pixel SP1, the first bank BANK1 may have a first opening OP11 and a second opening OP12. The first opening OP11 may correspond to the first light emitting element LD11. The second opening OP12 may correspond to the second light emitting element LD12. Accordingly, the first light emitting element LD11 may be exposed through the first opening OP11. A portion of the first anode electrode AE1 and a portion of the cathode electrode CE may be exposed through the first opening OP11. Furthermore, the second light emitting element LD12 may be exposed through the second opening OP12. A portion of the first anode electrode AE1 and a portion of the cathode electrode CE may be exposed through the second opening OP12. Hereinafter, redundant explanation of openings of the second sub-pixel SP1 and the third sub-pixel SP3 may be omitted.

The sub-pixel SP1 of the display device in accordance with an embodiment may include first and second light emitting elements LD11 and LD12 that are diagonally oriented. Hence, the first and second openings OP11 and OP12 that respectively correspond to the first and second light emitting elements LD11 and LD12 may also be diagonally formed.

In accordance with an embodiment illustrated in FIG. 13, the first opening OP11 and the second opening OP12 in the area of the first sub-pixel SP1 may be separated from each other. However, the disclosure is not limited to the aforementioned structure. The first light emitting element and the second light emitting element may be exposed through a single opening. For example, in the case where the distance between the first light emitting element and the second light emitting element in the second direction DR2 is reduced, the first light emitting element and the second light emitting element may be exposed through the single opening rather than through the first opening OP11 and the second opening OP12 that are separated from each other.

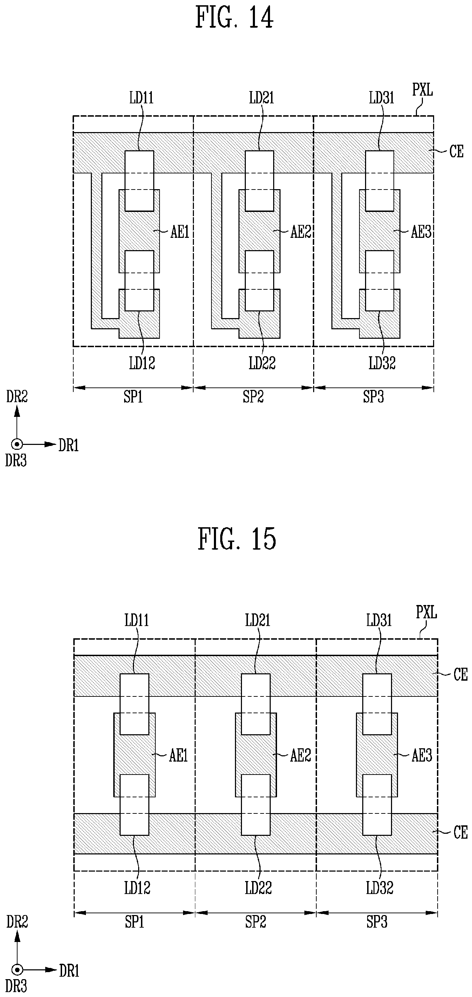

FIG. 14 is a schematic plan view illustrating a pixel included in a display device in accordance with an embodiment.

Referring to FIG. 14, the pixel PXL may include first to third sub-pixels SP1 to SP3. The first to third sub-pixels SP1 to SP3 may be arranged (or disposed) in the first direction DR1.

First to third anode electrodes AE1 to AE3 may be respectively disposed in the first to third sub-pixels SP1 to SP3. The first anode electrode AE1 may be connected to first and second light emitting elements LD11 and LD12 of the first sub-pixel SP1. The second anode electrode AE2 may be connected to first and second light emitting elements LD21 and LD22 of the second sub-pixel SP2. The third anode electrode AE3 may be connected to first and second light emitting elements LD31 and LD32 of the third sub-pixel SP3. The cathode electrode CE may be disposed at the same height as the first to third anode electrodes AE1 to AE3. The cathode electrode CE may be used as a common electrode for the pixel PXL and other pixels adjacent to the pixel PXL in a row direction.

Each of the first to third sub-pixels SP1 to SP3 may include two light emitting elements. As illustrated in FIG. 14, the first and second light emitting elements LD11 and LD12 included in the first sub-pixel SP1 may be connected in parallel between the first anode electrode AE1 and the cathode electrode CE. The first and second light emitting elements LD21 and LD22 included in the second sub-pixel SP2 may be connected in parallel between the second anode electrode AE2 and the cathode electrode CE. The first and second light emitting elements LD31 and LD32 included in the third sub-pixel SP3 may be connected in parallel between the third anode electrode AE3 and the cathode electrode CE.

In the display device in accordance with an embodiment, the first and second light emitting elements included in the sub-pixel may be oriented in the second direction DR2. Referring to the embodiment illustrated in FIG. 10, the first and second light emitting elements are diagonally oriented. In other words, in the embodiment of FIG. 10, the first and second light emitting elements are oriented such that the angle (θ) between the first line LN1 and the second line LN2 is greater than about 0° and less than about 90°. On the other hand, in accordance with the embodiment illustrated in FIG. 14, the first and second light emitting elements are oriented such that the angle (θ) between the first line LN1 and the second line LN2 is 0°. In other words, the first and second light emitting elements LD11 and LD12 are connected to the cathode electrode CE and the anode electrode AE1 in the second direction DR2.

In accordance with the embodiment illustrated in FIG. 14, the length of the sub-pixel in the first direction DR1 may be minimized.

FIG. 15 is a schematic plan view illustrating a pixel included in a display device in accordance with an embodiment.

Referring to FIG. 15, the pixel PXL may include first to third sub-pixels SP1 to SP3. The first to third sub-pixels SP1 to SP3 may be arranged (or disposed) in the first direction DR1. Hereinafter, descriptions overlapping those of FIG. 14 may be omitted.

Referring to FIG. 15, in the first to third sub-pixels SP1, SP2, and SP3, the first light emitting elements LD11, LD21, and LD31 may be connected to an upper cathode electrode CE, and the second light emitting elements LD12, LD22, and LD32 may be connected to a lower cathode electrode CE. Although not illustrated in FIG. 15, first light emitting elements of sub-pixels positioned in a row directly subsequent to a row configured of the first to third sub-pixels SP1, SP2, and SP3 may be connected to the lower cathode electrode CE of FIG. 15.

In the case of the embodiment of FIG. 14, because all of the first and second light emitting elements are required to be connected to the upper cathode electrode, an additional line component in the second direction is needed to connect the second light emitting elements LD12, LD22, and LD32 to the cathode electrode. Hence, space is required to form the additional line component in each sub-pixel area.

On the other hand, in the case of the embodiment of FIG. 15, the additional line component is not required. Accordingly, the length of the sub-pixel in the first direction DR1 may be further minimized.

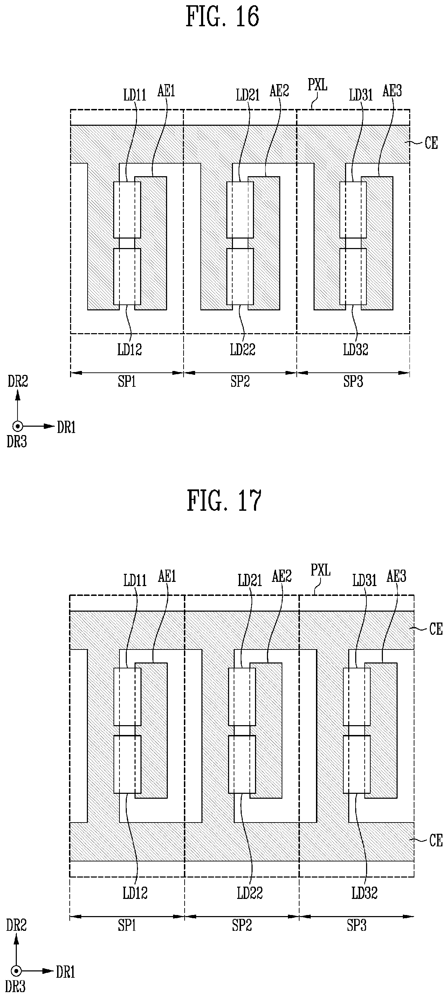

FIG. 16 is a schematic plan view illustrating a pixel included in a display device in accordance with an embodiment.

Referring to FIG. 16, the orientation of the first and second light emitting elements in the sub-pixel is similar to that of the embodiment of FIG. 14 or 15. In the case of the embodiments illustrated in FIGS. 14 and 15, the upper and lower ends of the first and second light emitting elements are connected to the cathode electrode or the anode electrode. On the other hand, in the embodiment of FIG. 16, left sides of the first and second light emitting elements LD11 and LD12 may be connected to the cathode electrode CE, and right sides thereof may be connected to the first anode electrode AE1. In other words, the first and second light emitting elements LD11 and LD12 may be connected to the cathode electrode CE and the anode electrode AE1 in the first direction DR1.

If the first and second light emitting elements arranged (or disposed) in an up and down direction are required to be connected to the cathode electrode and the anode electrode in a left and right direction due to design or production constraints of the light emitting elements, the light emitting elements may be disposed in the sub-pixel as shown in the embodiment of FIG. 16.

FIG. 17 is a schematic plan view illustrating a pixel included in a display device in accordance with an embodiment. In the following descriptions pertaining to FIG. 17, redundant descriptions overlapping those of FIG. 16 may be omitted.

Referring to FIG. 17, in the same manner as FIG. 16, the left sides of the first and second light emitting elements LD11 and LD12 may be connected to the cathode electrode CE, and the right sides thereof may be connected to the first anode electrode AE1. However, the cathode electrode CE illustrated in FIG. 17 may have a substantially mesh structure.

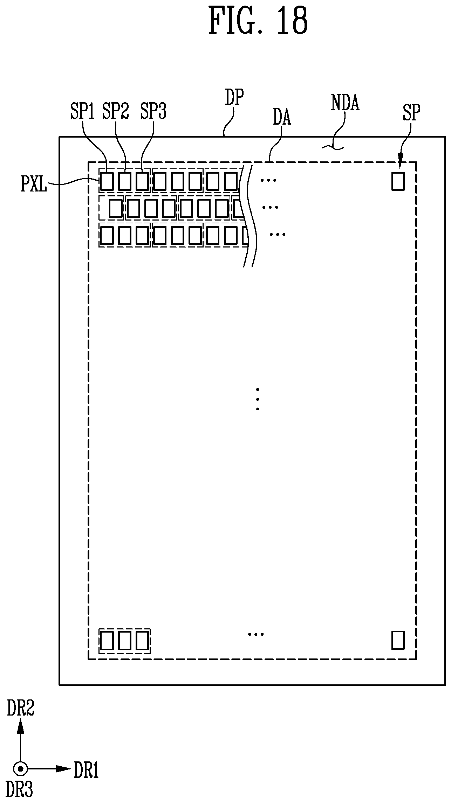

FIG. 18 is a schematic plan view illustrating another example of the display panel of FIG. 1.

Referring to FIG. 18, the display panel DP may include a display area DA and a non-display area NDA. The display panel DP may display an image through the display area DA. The non-display area NDA may be disposed around the display area DA.

The display panel DP may include sub-pixels SP in the display area DA. The sub-pixels SP may be arranged (or disposed) in a first direction DR1 and a second direction DR2 intersecting with the first direction DR1. In the embodiment of FIG. 3, the sub-pixels are arranged (or disposed) in the form of a matrix in the first direction DR1 and the second direction DR2. On the other hand, in the embodiment of FIG. 18, the sub-pixels SP may be arranged(or disposed) in a linear line in the first direction DR1, and may be arranged (or disposed) in a zigzag pattern in the second direction DR2. However, the aforementioned example is only for illustrative examples, and the sub-pixels SP may be arranged (or disposed) in a zigzag pattern in the first direction, and may be arranged (or disposed) in a linear line in the second direction.

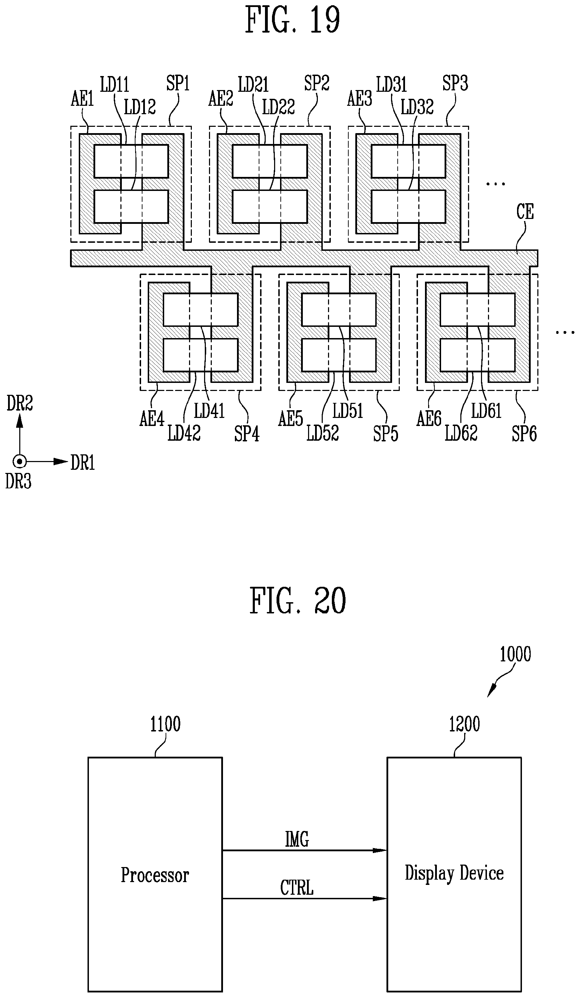

FIG. 19 is a schematic plan view illustrating an embodiment of sub-pixels of FIG. 18.

Referring to FIG. 19, there are illustrated three sub-pixels SP1, SP2, and SP3 that belong to a first row, and three sub-pixels SP4, SP5, and SP6 that belong to a second row. In the embodiment of FIG. 19, the first to third sub-pixels SP1 to SP3 may be arranged (or disposed) in a linear line in the first direction DR1 in a first row. The fourth to sixth sub-pixels SP4 to SP6 may be arranged (or disposed) in a linear line in the first direction DR1 in a second row. The first sub-pixel SP1 in the first row and the fourth sub-pixel SP4 in the second row may be arranged (or disposed) in a zigzag pattern in the second direction rather than being arranged (or disposed) in a linear line.

First to sixth sub-pixels SP1 to SP6 may respectively include corresponding first to sixth anode electrodes AE1 to AE6. Each of the first to sixth sub-pixels SP1 to SP6 may include two light emitting elements. In other words, the first sub-pixel SP1 may include first and second light emitting elements LD11 and LD12. The second sub-pixel SP2 may include first and second light emitting elements LD21 and LD22. The third sub-pixel SP3 may include first and second light emitting elements LD31 and LD32. Furthermore, the fourth sub-pixel SP4 may include first and second light emitting elements LD41 and LD42. The fifth sub-pixel SP5 may include first and second light emitting elements LD51 and LD52. The sixth sub-pixel SP6 may include first and second light emitting elements LD61 and LD62.

Referring to FIG. 19, the orientation of the first and second light emitting elements in the sub-pixel is similar to that of the embodiment of FIG. 16. In other words, the cathode electrode CE and the anode electrode may be connected to left and right sides of the first and second light emitting elements included in each of the sub-pixels.

In detail, the left sides of the first and second light emitting elements included in the first to sixth sub-pixels SP1 to SP6 illustrated in FIG. 19 may be connected to the anode electrodes AE1 to AE6, and the right sides thereof may be connected to the cathode electrode CE. However, the aforementioned example is only for illustrative purposes, and the sub-pixels may be configured such that the right sides of the first and second light emitting elements are connected to the anode electrodes AE1 to AE6, and the left sides thereof are connected the cathode electrode CE.

In the display device in accordance with an embodiment, sub-pixels positioned in a first row and sub-pixels positioned in a second row may share one cathode electrode CE1. In this case, sub-pixels positioned in a third row and sub-pixels positioned in a fourth row may share one cathode electrode CE1. However, the aforementioned example is only for illustrative purposes, and the cathode electrode may be configured in the form of a mesh, as illustrated in FIG. 17.

FIG. 20 is a block diagram illustrating an embodiment of a display system.

Referring to FIG. 20, the display system 1000 may include a processor 1100 and a display device 1200.

The processor 1100 may perform various tasks and operations. In embodiments, the processor 1100 may include an application processor, a graphic processor, a microprocessor, a central processing unit (CPU), and so on. The processor 1100 may be connected to the other components of the display system 1000 through a bus system to control the components.

The processor 1100 may transmit image data IMG and a control signal CTRL to the display device 1200. The display device 1200 may display an image based on the image data IMG and the control signal CTRL. The display device 1200 may be configured in the same manner as the display device DD described with reference to FIG. 1. In this case, the image data IMG and the control signal CTRL may be provided as the input image data IMG and the control signal CTRL of FIG. 1, respectively.

The display system 1000 may include computing systems that provide an image display function, such as a smart watch, a mobile phone, a smart phone, a portable computer, a tablet personal computer (tablet PC), a watch phone, an automotive display, smart glasses, a portable multimedia player (PMP), a navigation system, and an ultra mobile personal computer (UMPC). Furthermore, the display system 1000 may include at least one of a head mounted display (HMD), a virtual reality (VR) device, a mixed reality (MR) device, and an augmented reality (AR) device.

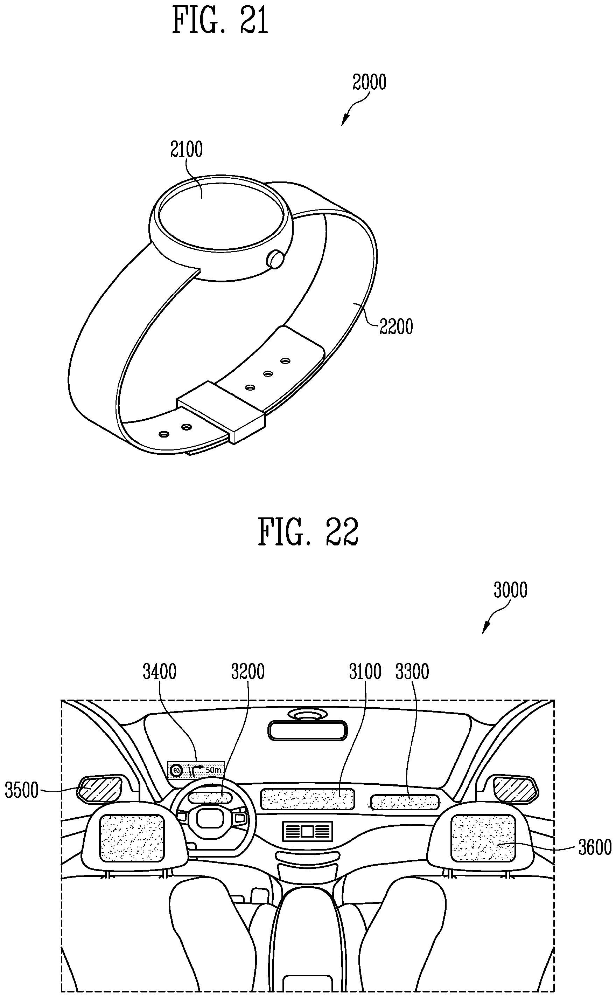

FIGS. 21 to 24 are schematic perspective views illustrating application examples of a display system of FIG. 20.

Referring to FIG. 21, the display system 1000 of FIG. 20 may be applied to a smart watch 2000 including a display component 2100 and a strap 2200.

The smart watch 2000 may be a wearable electronic device. For example, the smart watch 2000 may have a structure in which the strap 2200 may be mounted on the wrist of the user. Here, the display system 1000 and/or the display device 1200 may be applied to the display component 2100, so that image data including time information can be provided to the user.

Referring to FIG. 22, the display system 1000 of FIG. 20 may be applied to the automotive display system 3000. Here, the automotive display system 3000 may include a computing system that is provided inside and/or outside a vehicle to provide image data.

For example, the display system 1000 and/or the display device 1200 may be applied to at least any one of an infotainment panel 3100, a cluster 3200, a co-driver display 3300, a head-up display 3400, a side mirror display 3500, and a rear seat display 3600, which may be provided in the vehicle.

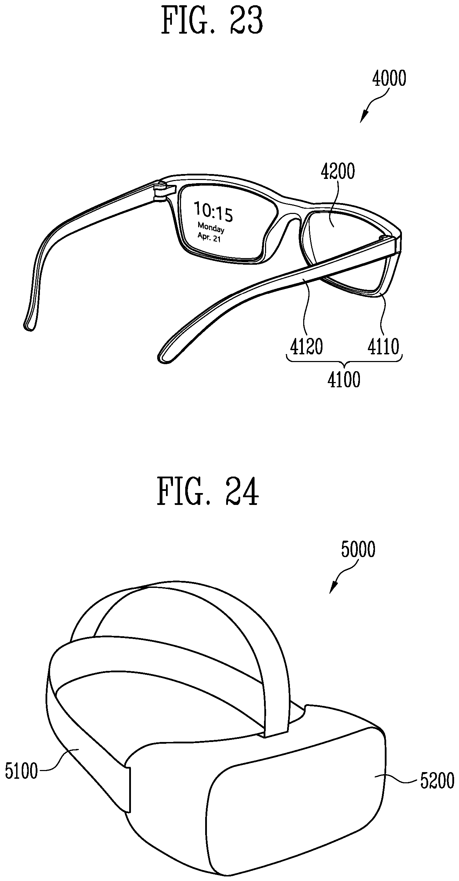

Referring to FIG. 23, the display system 1000 of FIG. 20 may be applied to smart glasses 4000. The smart glasses 4000 may be a wearable electronic device capable of being worn on the head of the user. For example, the smart glasses 4000 may be a wearable device for augmented reality.

The smart glasses 4000 may include a frame 4100 and a lens component 4200. The frame 4100 may include a housing 4110 which supports the lens component 4200, and a leg component 4120 enabling the user to wear the smart glasses. The leg component 4120 may be connected to the housing 4110 by a hinge, and thus can be folded or unfolded with respect to the housing 4110.

The frame 4100 may be equipped with a battery, a touch pad, a microphone, a camera, and the like within the scope of the disclosure. Furthermore, the frame 4100 may be equipped with a projector configured to output light, and a processor configured to control a light signal and the like within the scope of the disclosure.

The lens component 4200 may include an optical component configured to transmit or reflect light. For example, the lens component 4200 may include glass, transparent synthetic resin, and the like within the scope of the disclosure.

To enable the eyes of the user to perceive visual information, the lens component 4200 may reflect images by an optical signal transmitted from the projector of the frame 4100 by a rear surface of the lens component 4200 (for example, a surface facing the eyes of the user). For example, the user may perceive visual information such as time and date displayed on the lens component 4200. Here, the protector and/or the lens component 4200 may be a kind of display device. The display device 1200 may be applied to the protector and/or the lens component 4200.

Referring to FIG. 24, the display system 1000 of FIG. 20 may be applied to a head mounted display device 500.

The head mounted display device 5000 may be a wearable electronic device, which can be worn on the head of the user. For example, the head mounted display device 5000 may be a wearable device for virtual reality or mixed reality.

The head mounted display 5000 may include a head mounted band 5100 and a display device reception casing 5200. The head mounted band 5100 may be connected to the display device reception casing 5200. The head mounted band 5100 may include a horizontal band and/or a vertical band to fasten the head mounted display 5000 to the head of the user. The horizontal band may enclose the sides of the head of the user, and the vertical band may enclose the top of the head of the user. However, embodiments are not limited to the aforementioned example. For example, the head mounted band 5100 may be implemented in the form of eyeglass frames, a helmet, and so on.

The display device reception casing 5200 may receive the display system 1000 and/or the display device 1200.

In a display device in accordance with the disclosure, even if a defect occurs in any one light emitting element, a sub-pixel may function as a normal light emitting element.

Although embodiments and implementations have been described herein, other embodiments and modifications will be apparent from the foregoing description. Accordingly, the disclosure is not limited to the foregoing embodiments, but rather to the broader scope of the claims and various modifications and equivalent arrangements.

## Claims

1. A display device (1200), comprising:
a pixel circuit layer (PCL) disposed on a substrate;
an anode electrode (AE) disposed on the pixel circuit layer;
a cathode electrode (CE) disposed on the pixel circuit layer and spaced apart from the anode electrode; and
a first light emitting element (LD11) and a second light emitting element (LD12) electrically connected in parallel between the anode electrode and the cathode electrode,
wherein the first light emitting element (LD11) and the second light emitting element (LD12) are spaced apart from each other in a second direction and oriented diagonally.

2. The display device (1200) according to claim 1, wherein the display device further includes a first line (LN1) connecting respective centers of the first light emitting element (LD11) and the second light emitting element (LD12); and
a second line (LN2)connecting a center of an area where the first light emitting element (LD11) overlaps the cathode electrode and a center of an area where the first light emitting element (LD11) overlaps the anode electrode,
an angle between the first line and the second line is greater than 0° and less than 90°.

3. The display device (1200) according to claim 1 or 2, wherein the first light emitting element (LD11) and the second light emitting element (LD12) are included in a single sub-pixel.

4. The display device (1200) according to any of the preceding claims, wherein the cathode electrode(CE) has a mesh structure.

5. The display device (1200) according to claim 4, wherein the cathode electrode (CE) comprises:
a plurality of first line components (CE1) extending in a first direction perpendicular to the second direction; and
a plurality of second line components (CE2) extending in the second direction and respectively connected to the plurality of first line components.

6. The display device (1200) according to claim 4 or 5, wherein the cathode electrode (CE) further comprises a protrusion (CE3) protruding from each of the plurality of first line components in a direction toward the first light emitting element or the second light emitting element.

7. The display device (1200) according to claim 5, wherein the cathode electrode (CE) further comprises a protrusion protruding from each of the plurality of second line components in a direction toward the first light emitting element or the second light emitting element.

8. The display device (1200) according to any of the preceding claims, further comprising:
a bank including at least one opening through which the first light emitting element (LD11) and the second light emitting element (LD12) are exposed.

9. The display device (1200) according to claim 8, wherein the first light emitting element (LD11) and the second light emitting element (LD12) are exposed through the one opening of the bank.

10. The display device (1200) according to claim 8 or 9, wherein the first light emitting element (LD11) is exposed through a first opening of the bank, and the second light emitting element (LD11) is exposed through a second opening of the bank separated from the first opening of the bank.
